# EUROPEAN PATENT APPLICATION

(11) **EP 4 742 438 A1**
(43) Date of publication of application: **13.05.2026**
(21) Application number: 24896461.1
(22) Date of filing: 25.11.2024
(51) Int. Cl.: H01Q 1/22, H05K 5/02, H01Q 1/36, H01Q 1/48, H05K 5/00, H05K 9/00, H05K 7/02, H01Q 1/52

(54) **TERMINAL DEVICE**

(30) Priority: 27.11.2023 CN 202311604085
(71) Applicant: Huawei Technologies Co., Ltd., Shenzhen, Guangdong 518129 (CN)
(72) Inventor: LIU, Bing, Shenzhen, Guangdong 518129 (CN); LI, Kun, Shenzhen, Guangdong 518129 (CN); SUN, Qiao, Shenzhen, Guangdong 518129 (CN); LI, Lingzhi, Shenzhen, Guangdong 518129 (CN); GOU, Xiaogang, Shenzhen, Guangdong 518129 (CN); ZHAO, Menglong, Shenzhen, Guangdong 518129 (CN)
(74) Representative: Epping - Hermann - Fischer
(86) International application number: PCT/CN2024/134133
(87) International publication number: WO 2025/113372

(57) **Abstract**

This application discloses a terminal device, including a display structure, a shielding structure, and an antenna. A second part of the shielding structure is disposed on a periphery of a side surface of the display structure, and the second part is used to isolate a signal between a radiator of the antenna and the side surface, thereby reducing an absorption loss of the display structure on the antenna. This application facilitates miniaturization and a high screen-to-body ratio of the terminal device, and can ensure performance of the antenna.

## Description

This application claims priority to Chinese Patent Application No. 202311604085.X, filed with the China National Intellectual Property Administration on November 27, 2023 and entitled "TERMINAL DEVICE", which is incorporated herein by reference in its entirety.

### TECHNICAL FIELD

The present invention relates to the field of radio frequency communication technologies, and in particular, to a terminal device.

### BACKGROUND

Terminal devices are small and compactly stacked, continually pursuing miniaturization, slim profiles, and high screen-to-body ratios, to achieve superior aesthetics and texture. Right next to terminal antennas, there are almost components with poor conductivity and high loss, which are referred to as lossy components. For example, in watches and mobile phones, their screens are typical lossy components. The lossy component causes absorption of radiation efficiency of the antenna, leading to significant deterioration in performance of the antenna. A closer distance between the lossy component and a radiator of the antenna indicates smaller antenna clearance and greater deterioration in the performance of the antenna caused by the lossy component. In antenna design, the radiator is usually far away from the lossy component to reduce absorption. However, this method is increasingly constrained by the push for high screen-to-body ratios.

Therefore, there is an urgent need for new antenna design technologies to resolve the antenna design challenges posed by miniaturization of terminal devices and their high screen-to-body ratios.

### SUMMARY

This application provides a terminal device, to help implement miniaturization and a high screen-to-body ratio of the terminal device, reduce an absorption loss caused by a display module to an antenna in the terminal device, and ensure performance of the antenna.

According to a first aspect, an embodiment of this application provides a terminal device. The terminal device includes a display structure, a shielding structure, and an antenna. The display structure includes a first surface, a second surface, and a side surface. The first surface and the second surface are disposed opposite to each other, and an orientation of the side surface differs from that of the first surface. Specifically, the side surface faces a side frame of the terminal device, and the side surface may be connected between the first surface and the second surface. At least a part of the first surface forms a display surface of a screen of the terminal device. The shielding structure includes a conductive material, the shielding structure includes a first part and a second part, the first part is located on a side that is of the second surface and that is away from the first surface, the first part covers at least a part of the second surface, and the second part is located on a periphery of the side surface and directly faces at least a part of the side surface. The antenna includes a radiator, and the radiator is located on the periphery of the side surface. The second part is located between the radiator and the side surface, to isolate at least a part of a signal between the radiator and the display structure. In a direction perpendicular to the side surface, a distance between the radiator and the second part is greater than a distance between the second part and the side surface.

In this embodiment of this application, the shielding structure is disposed on a periphery of the display structure, the first part of the shielding structure covers the second surface, and the second part is disposed on the periphery of the side surface and directly faces the side surface, so that an absorption loss of the display structure on the terminal device can be reduced. Specifically, the second part of the shielding structure is disposed on the periphery of the side surface of the display structure and is located between the side surface and the radiator. Because the shielding structure includes the conductive material, the conductive material of the second part can isolate a signal between the side surface and the radiator of the antenna. This may be understood as follows: Existence of the second part can reduce coupling of a signal of the radiator of the antenna to the display structure, thereby resolving a problem of an absorption loss of the display structure on the antenna. If there is no second part, because the display structure has the conductive material, a signal of the radiator of the antenna is coupled to the display structure, the display structure is excited to generate a current, and the display structure absorbs a part of the signal of the radiator of the antenna, causing an absorption loss.

In a possible implementation, the second part is interconnected with the first part, so that the shielding structure forms an integrated film structure or plate structure with a bent edge. In this solution, an interconnection relationship between the second part and the first part is limited, so that the shielding structure forms the integrated film structure or plate structure, and a connection between the first part and the second part forms a structure of a shielding can, to shield the display structure. This helps reduce an absorption loss of the display structure, and improve performance of the antenna.

In a possible implementation, the first part is attached to the second surface, and a first direction is a direction perpendicular to the second surface; and in the first direction, a vertical distance between the first surface and the second surface is a first size, a height by which a top of the second part protrudes relative to the first part is a second size, the first size is less than or equal to the second size, and the top of the second part is an end that is of the second part and that is away from the first part. In this solution, the height by which the top of the second part protrudes relative to the first part is constrained to be greater than the vertical distance between the first surface and the second surface, so that a position of the top of the second part is above the first surface in the first direction, the height by which the second part protrudes relative to the first part protrudes from the first surface of the display structure, and in the direction perpendicular to the side surface, the second part completely blocks the display structure on the periphery of the side surface. This solution helps reduce an absorption loss of the display structure and improve performance of the antenna.

In a possible implementation, the terminal device includes a cover and a side frame, the radiator is at least a part of the side frame, the cover is stacked outside the first surface of the display structure and is connected to the side frame, an ink layer is disposed on an inner surface of the cover, the ink layer is correspondingly disposed at an edge of the first surface and a periphery of the edge, and there is a gap between the top of the second part and the ink layer. In this solution, the gap is formed between the top of the second part and the ink layer, so that the second part is prevented from scratching the ink layer in a process of assembling the shielding structure, to ensure safety of the ink layer and prevent the ink layer from being scratched.

In a possible implementation, there is a gap between the second part and the side surface of the display structure. This solution provides a design solution in which the shielding structure is the shielding can independent of the display structure. A gap formed between the second part and the side surface prevents the second part from scratching the side surface in a process of assembling the shielding structure and the display structure. The side surface of the display structure is a stress concentration position, and scratching of the second part easily causes a phenomenon such as a crack on an edge of the display structure. Therefore, this solution helps ensure security of the display structure.

In a possible implementation, based on a solution in which a gap is maintained between the second part and the side surface, in a design in which the shielding structure is an independent shielding can structure, the terminal device further includes a near field communication (NFC) antenna, the near field communication (NFC) antenna is attached to the second surface of the display structure, and the first part of the shielding structure is attached to the second surface, so that the near field communication (NFC) antenna is sandwiched between the first part and the second surface, an FPC of the display structure is led out from an opening position formed by the second part, and the FPC is stacked on a surface that is of the first part and that is away from the display structure. In a possible implementation, the second part is attached to the side surface of the display structure. This solution provides a design solution in which the shielding structure is formed by spraying a coating or a film structure on an outer surface of the display structure. In this solution, the second part is attached to the side surface. This solution helps reduce volumes of the shielding structure and the display structure, and can also expand clearance of the antenna, thereby helping improve performance of the antenna.

In a possible implementation, based on a design in which the shielding structure is sprayed on the second surface and the side surface of the display structure by spraying a metal material, the metal material sprayed on the side surface forms the second part of the shielding structure. In this solution, the display structure and the cover (a protective layer, for example, glass or sapphire) of the terminal device are attached by using an optical adhesive, an edge of the cover exceeds an edge of the display structure, a top of the second part covers an inner surface of a part of the cover, and a width of the second part covering the inner surface of the cover is controlled within 0.2 mm, to ensure good clearance of the antenna.

In a possible implementation, the second surface of the display structure is attached to the NFC antenna, the FPC of the display structure is stacked on the second surface, the near field communication (NFC) antenna is clamped between the FPC and the second surface, the first part of the shielding structure is sprayed on an outer surface of the FPC, but it needs to be ensured that a connector of the FPC is exposed, and the first part does not cover the connector of the FPC, so that the connector of the FPC can be electrically connected to a chip on a mainboard of the terminal device.

In a possible implementation, the display structure includes a display layer and a touch layer, the touch layer and the display layer are stacked, the display layer is located between the touch layer and the first part, a vertical distance between a surface that is of the touch layer and that is away from the display layer and the first part is less than or equal to the height by which the top of the second part protrudes relative to the first part, and the top of the second part is the end that is of the second part and that is away from the first part. In this solution, the display structure is refined into the display layer and the touch layer, and a height of the second part is constrained to be greater than or equal to a thickness of the display layer, so as to reduce signal coupling by shielding the display layer.

In a possible implementation, the display structure includes a display layer and a touch layer, the touch layer and the display layer are stacked, and the display layer is located between the touch layer and the first part; and in the direction perpendicular to the side surface, an edge of the touch layer is inwardly retracted relative to an edge of the display layer, and a distance between the edge of the touch layer and the second part is greater than a distance between the side surface and the second part. In this solution, on the basis of setting the shielding structure, the edge of the touch layer is inwardly retracted relative to the edge of the display layer. Therefore, the solution in which the touch layer is inwardly retracted can reduce an absorption loss of the display structure.

In a possible implementation, a size of the edge that is of the touch layer and that is inwardly retracted relative to the edge of the display layer ranges from 0.5 mm to 1 mm. In this solution, a size range in which the touch layer is inwardly retracted is limited, so that a touch function of the touch layer is not affected, and providing a proper range also has a positive impact on reducing an absorption loss.

In a possible implementation, there is a spacing layer structure between the touch layer and the display layer, and a thickness of the spacing layer structure is 0.3 mm. Disposing of the spacing layer and a constraint on the thickness of the spacing layer help ensure a product yield rate of the display structure.

In a possible implementation, the vertical distance between the surface that is of the touch layer and that is away from the display layer and the first part is less than or equal to the height by which the top of the second part protrudes relative to the first part, and the top of the second part is the end that is of the second part and that is away from the first part. In this solution, the height by which the second part protrudes from the periphery of the side surface is limited to exceed the touch layer, thereby improving shielding effect.

In a possible implementation, the conductive material of the shielding structure is at least one of stainless steel, silver paste, copper, or conductive fabric, or a combination of at least two thereof. In this solution, a plurality of materials of the shielding structure are provided, so that the shielding structure is easy to manufacture and implement, and a function of reducing an absorption loss of the display structure can also be ensured by using these materials.

In a possible implementation, the second part is connected to an edge of the first part, the second part forms a surrounding structure with an opening, the surrounding structure surrounds the first part, and the opening is used to provide clearance for a component in the terminal device. This solution, through the second part surrounding design that creates an opening, provides clearance for other components within the terminal device, for example, an FPC, thereby facilitating a thin design of the terminal device.

According to a second aspect, this application provides a terminal device, including a display structure and an antenna. The display structure includes a first surface and a second surface that are disposed opposite to each other, and a side surface connected between the first surface and the second surface. At least a part of the first surface forms a display surface of a screen of the terminal device. The display structure includes a display layer and a touch layer that are stacked, and an edge of the touch layer is inwardly retracted relative to an edge of the display layer. The antenna includes a radiator, the radiator is located on a periphery of the side surface and is spaced from the display structure, and in a direction perpendicular to the side surface, a distance between the radiator and the edge of the touch layer is greater than a distance between the radiator and the edge of the display layer.

In this solution, the edge of the touch layer of the display structure is inwardly retracted relative to the edge of the display layer, to reduce coupling of the display structure to a signal of the radiator of the antenna, and improve performance of the antenna. Specifically, touch lines in the touch layer are interleaved, and the distance between the radiator and the edge of the touch layer is increased, so that a signal of the antenna coupled on the touch layer can be reduced. Therefore, this solution can reduce an absorption loss of the display structure on the signal of the antenna.

In a possible implementation, a size of the edge that is of the touch layer and that is inwardly retracted relative to the edge of the display layer ranges from 0.5 mm to 1 mm. In this solution, a size range in which the touch layer is inwardly retracted is limited, so that a touch function of the touch layer is not affected, and providing a proper range also has a positive impact on reducing an absorption loss.

In a possible implementation, the terminal device further includes a shielding structure, the shielding structure includes a conductive material, and a part of the shielding structure is located between the side surface and the radiator, and is configured to isolate at least a part of a signal between the radiator and the display structure. In this solution, the shielding structure is disposed, and a part of the shielding structure is disposed between the side surface and the radiator, so that an absorption loss of the display structure on the terminal device can be reduced. Specifically, the part of the shielding structure is disposed on the periphery of the side surface of the display structure and is located between the side surface and the radiator. Because the shielding structure includes the conductive material, the conductive material can isolate a signal between the side surface and the radiator of the antenna. This may be understood as follows: The part of the shielding structure can reduce coupling of a signal of the radiator of the antenna to the display structure, thereby resolving a problem of an absorption loss of the display structure on the antenna. If the part of the shielding structure does not exist, because the display structure has the conductive material, a signal of the radiator of the antenna is coupled to the display structure, the display structure is excited to generate a current, and the display structure absorbs a part of the signal of the radiator of the antenna, causing an absorption loss.

In a possible implementation, the shielding structure includes a first part and a second part, the first part is connected to the second surface and covers at least a part of the second surface, the second part is located on the periphery of the side surface and there is a gap between the second part and the side surface of the display structure, or the second part is attached to the side surface of the display structure. In this solution, a gap formed between the second part and the side surface of the display structure helps ensure safety of the display structure, and prevents the second part from scratching the side surface in a process of assembling the shielding structure and the display structure. The side surface of the display structure is a stress concentration position, and scratching of the second part easily causes a phenomenon such as a crack on an edge of the display structure. In this solution, a design in which the second part is attached to the side surface of the display structure helps reduce volumes of the shielding structure and the display structure, and also expand clearance of the antenna, thereby helping improve performance of the antenna.

In a possible implementation, based on a design in which the shielding structure is sprayed on the second surface and the side surface of the display structure by spraying a metal material, the metal material sprayed on the side surface forms the second part of the shielding structure. In this solution, the display structure and a cover (a protective layer, for example, glass or sapphire) of the terminal device are attached by using an optical adhesive, an edge of the cover exceeds the edge of the display structure, a top of the second part covers an inner surface of a part of the cover, and a width of the second part covering the inner surface of the cover is controlled within 0.2 mm, to ensure good clearance of the antenna.

In a possible implementation, based on a solution in which a gap is maintained between the second part and the side surface, in a design in which the shielding structure is an independent shielding can structure, the terminal device further includes a near field communication (NFC) antenna, the near field communication (NFC) antenna is attached to the second surface of the display structure, and the first part of the shielding structure is attached to the second surface, so that the near field communication (NFC) antenna is sandwiched between the first part and the second surface, an FPC of the display structure is led out from an opening position formed by the second part, and the FPC is stacked on a surface that is of the first part and that is away from the display structure. In a possible implementation, a vertical distance between a surface that is of the touch layer and that is away from the display layer and the first part is less than a height by which a top of the second part protrudes relative to the first part, and the top of the second part is an end that is of the second part and that is away from the first part. In this solution, the height by which the second part protrudes from the periphery of the side surface is limited to exceed the touch layer, thereby improving shielding effect.

According to a third aspect, this application provides a terminal device. The terminal device includes a display structure and an antenna, the display structure includes a first surface and a second surface that are disposed opposite to each other, and a side surface connected between the first surface and the second surface. At least a part of the first surface forms a display surface of a screen of the terminal device. The display structure includes a substrate, a main structure, and an edge structure. The substrate includes a top surface and a bottom surface that are disposed opposite to each other. The main structure and the edge structure are formed on the top surface of the substrate. The main structure includes a display layer and a touch layer that are stacked in a direction perpendicular to the top surface. The edge structure is at least partially disposed around a periphery of the main structure. The edge structure includes a shielding wall. In a direction perpendicular to the side surface, the shielding wall covers at least a part of the main structure. The antenna includes a radiator, and the radiator is located on a periphery of the side surface and is spaced from the display structure. In the direction perpendicular to the side surface, the shielding wall is located between the radiator and the main structure, to isolate at least a part of a signal between the radiator and the main structure, and a distance between the radiator and the shielding wall is greater than a distance between the shielding wall and the main structure.

In this solution, the shielding wall is manufactured inside the display structure by using a manufacturing process of the display structure, is integrally formed with the display structure, and does not need to be additionally assembled, thereby reducing a risk of damaging the display structure in an assembly process. In addition, the shielding wall is closer to a main part inside the display structure, and provides clearance for the antenna, thereby helping improve performance of the antenna.

In a possible implementation, the edge structure includes an isolation part, the isolation part is located between the shielding wall and the main structure, the isolation part specifically has an accommodation space, and the accommodation space is configured to accommodate a conductive material that flows from the main structure to the isolation part in a process of manufacturing the main structure. In a specific implementation, in a process of manufacturing the main structure, a conductive material may be printed on the substrate by using a manufacturing process such as spraying or printing. In the manufacturing process, the conductive material is in a liquid state and has fluidity. In this solution, the isolation part is disposed in a region between the shielding wall and the edge of the main structure, and the isolation part is similar to a dam structure, and can prevent the conductive material from flowing to a position of the shielding wall.

In a possible implementation, the display structure further includes a shielding layer, the shielding layer is located on a side of the bottom surface of the substrate, and the shielding layer covers at least a part of the main structure. The shielding layer is spaced between a circuit board and the display structure, and the shielding layer can reduce a loss caused by signal absorption of the display structure on a radio frequency line on the circuit board.

In a possible implementation, the shielding layer is electrically connected to the shielding wall through a via hole on the substrate.

In a possible implementation, the shielding wall forms a surrounding structure with an opening, the display structure includes an edge cable, the edge cable is stacked on a side that is of the edge structure and that is away from the substrate, the edge cable is electrically connected to the main structure, and the edge cable passes through the opening and extends to a periphery of the edge structure.

According to a fourth aspect, an embodiment of this application provides a display module. The display module includes a display structure and a shielding structure. The display structure includes a first surface and a second surface that are disposed opposite to each other, and a side surface connected between the first surface and the second surface. At least a part of the first surface forms a display surface of a screen of a terminal device. The shielding structure includes a conductive material. The shielding structure includes a first part and a second part. The first part is connected to the second surface, and covers at least a part of the second surface. The second part is located on a periphery of the side surface and is spaced from and directly faces the side surface. The second part is configured to isolate at least a part of a signal between the display structure and a radiator of an antenna of the terminal device.

According to a fifth aspect, an embodiment of this application provides a display module. The display module includes a first surface and a second surface that are disposed opposite to each other, and a side surface connected between the first surface and the second surface. At least a part of the first surface forms a display surface of a screen of a terminal device. The display module includes a display layer and a touch layer that are stacked. An edge of the touch layer is inwardly retracted relative to an edge of the display layer.

According to a sixth aspect, an embodiment of this application provides a display module. The display module includes a first surface and a second surface that are disposed opposite to each other, and a side surface connected between the first surface and the second surface. At least a part of the first surface forms a display surface of a screen of a terminal device. The display module includes a substrate, a main structure, and an edge structure. The substrate includes a top surface and a bottom surface that are disposed opposite to each other. The main structure and the edge structure are formed on the top surface of the substrate. The main structure includes a display layer and a touch layer that are stacked in a direction perpendicular to the top surface. The edge structure is at least partially disposed around a periphery of the main structure. The edge structure includes a shielding wall. In a direction perpendicular to the side surface, the shielding wall covers at least a part of the main structure.

### BRIEF DESCRIPTION OF DRAWINGS

FIG. 1 is a partial diagram of a terminal device according to an implementation of this application;
FIG. 2 is a partial diagram of a terminal device according to an implementation of this application;
FIG. 3 is a diagram of a plane in which a display screen of a terminal device is located according to an implementation of this application;
FIG. 4 is a diagram of a plane in which a display screen of a terminal device is located according to an implementation of this application;
FIG. 5 is a diagram of a terminal device according to an implementation of this application;
FIG. 6 is a diagram of a terminal device according to an implementation of this application;
FIG. 7A is a diagram of a terminal device according to an implementation of this application;
FIG. 7B is a partially enlarged diagram of a terminal device according to an implementation of this application;
FIG. 7C is a partially enlarged diagram of a terminal device according to an implementation of this application;
FIG. 8 is a diagram of a specific structural design between a display structure and a shielding structure that are in a terminal device according to an implementation of this application;
FIG. 9A is a diagram of a specific structural design between a display structure and a shielding structure that are in a terminal device according to an implementation of this application;
FIG. 9B is a diagram of a specific structural design between a display structure and a shielding structure that are in a terminal device according to an implementation of this application;
FIG. 10 is a diagram of a terminal device according to an implementation of this application;
FIG. 11 is a partially enlarged diagram of a display structure according to an implementation of a terminal device shown in FIG. 10;
FIG. 12 is a planar diagram of a display structure according to an implementation of a terminal device shown in FIG. 10;
FIG. 13 is a diagram of a terminal device according to an implementation of this application;
FIG. 14 is a sectional view of a terminal device shown in FIG. 13;
FIG. 15 is an enlarged diagram of a part I in FIG. 14;
FIG. 16 is a three-dimensional diagram of a shielding structure in a terminal device shown in FIG. 13;
FIG. 17 is an enlarged diagram of a part II in FIG. 16;
FIG. 18 is a diagram of a terminal device according to an implementation of this application;
FIG. 19 is a sectional view of a terminal device shown in FIG. 18;
FIG. 20 is an enlarged diagram of a part III in FIG. 19;
FIG. 21 is a three-dimensional diagram of a shielding structure in a terminal device shown in FIG. 18;
FIG. 22 is an enlarged diagram of a part IV in FIG. 21;
FIG. 23A shows structures of five different test solutions;
FIG. 23B simulated absorption-loss curves for radiators generated based on the five solutions shown in FIG. 23A;
FIG. 24 is a curve comparison diagram of absorption losses generated by materials of different structures based on Solution 4 shown in FIG. 23A;
FIG. 25 is a curve comparison diagram of absorption losses generated by materials of different structures based on Solution 5 shown in FIG. 23A;
FIG. 26 is a diagram of an antenna current and electric field distribution in Solution 2 in FIG. 23A;
FIG. 27 is a diagram of an antenna current and electric field distribution in Solution 5 in FIG. 23A;
FIG. 28 shows a comparison between an S11 curve diagram of an antenna system in a solution with a shielding structure and an S11 curve diagram of an antenna system of a terminal device in which no shielding structure is disposed according to specific implementations of this application;
FIG. 29 shows a comparison between a curve diagram of radiation efficiency of an antenna system in a solution with a shielding structure and a curve diagram of radiation efficiency of an antenna system of a terminal device in which no shielding structure is disposed according to specific implementations of this application;
FIG. 30 shows a comparison between an S11 curve diagram of an antenna system in a solution in which an edge of a touch layer is inwardly retracted and an S11 curve diagram of an antenna system in a solution in which a touch layer is not designed to inwardly retract in a display structure according to specific implementations of this application;
FIG. 31 shows a comparison between a curve diagram of radiation efficiency of an antenna system in a solution in which an edge of a touch layer is inwardly retracted and a curve diagram of radiation efficiency of an antenna system in a solution in which a touch layer is not designed to inwardly retract according to specific implementations of this application;
FIG. 32 shows a comparison between an S11 curve diagram of an antenna system in a solution in which a shielding structure is disposed and an edge of a touch layer is inwardly retracted and an S11 curve diagram of an antenna system in a solution in which no shielding structure is disposed and a touch layer is not designed to inwardly retract in a display structure according to specific implementations of this application; and
FIG. 33 shows a comparison between a curve diagram of radiation efficiency of an antenna system in a solution in which a shielding structure is disposed and an edge of a touch layer is inwardly retracted and a curve diagram of radiation efficiency of an antenna system in a solution in which no shielding structure is disposed and a touch layer is not designed to inwardly retract according to specific implementations of this application.

### DESCRIPTION OF EMBODIMENTS

### Term explanation

A radiator (or antenna stub) is an apparatus configured to receive/send electromagnetic wave radiation in an antenna. In some cases, "antenna" is understood as the radiator (or antenna stub) in a narrow sense. The antenna converts guided wave energy from a transmitter into a radio wave, or converts a radio wave into guided wave energy, to radiate and receive a radio wave. Modulated high-frequency current energy (or guided wave energy) generated by the transmitter is transmitted to a transmit radiator (or antenna stub) via a feeder wire. The radiator (or antenna stub) converts the modulated high-frequency current energy into specific polarized electromagnetic wave energy and radiates the electromagnetic wave energy in a desirable direction. A receive radiator (or antenna stub) converts specific polarized electromagnetic wave energy from a specific direction of a space into modulated high-frequency current energy, and transmits the modulated high-frequency current energy to an input end of a receiver via a feeder wire.

The radiator (or antenna stub) may include a conductor having a specific shape and size, for example, a linear or sheet-like conductor. A specific shape is not limited in this application. In an embodiment, a linear radiator (or antenna stub) may be referred to as a linear antenna. In an embodiment, the linear radiator may be implemented by a conductive side frame, and may also be referred to as a side frame antenna. In an embodiment, the linear radiator (or antenna stub) may be implemented by a bracketed conductor, and may also be referred to as a bracketed antenna. In an embodiment, a conductor diameter (for example, including a thickness and a width) of the linear radiator or a radiator of the linear antenna is far less than a wavelength (for example, a dielectric wavelength) (for example, is less than 1/16 of the wavelength), and a length of the linear radiator or the radiator of the linear antenna may be compared with the wavelength (for example, the dielectric wavelength) (for example, the length is approximately 1/8 of the wavelength, or 1/8 to 1/4 of the wavelength, or 1/4 to 1/2 of the wavelength, or greater). Main forms of the linear antenna include a dipole antenna, a half-wave dipole antenna, a monopole antenna, a loop antenna, an inverted F antenna (also referred to as an IFA, Inverted F Antenna), and a planar inverted F antenna (also referred to as a PIFA, Planar Inverted F Antenna). For example, for the dipole antenna, each dipole antenna usually includes two radiation stubs, and each stub is fed by a feeding part from a feeding end of the radiation stub. For example, the inverted F antenna (Inverted-F Antenna, IFA) may be considered as being obtained by adding a grounding path to a monopole antenna. The IFA antenna has a feeding point and a grounding point, and is referred to as the inverted F antenna because a side view of the IFA antenna is in an inverted F shape. In an embodiment, a sheet-like radiator (or antenna stub) may include a microstrip antenna or a patch (patch) antenna. In an embodiment, the sheet-like radiator (or antenna stub) may be implemented by a planar conductor (for example, a conductive sheet or a conductive coating). In an embodiment, the sheet-like radiator (or antenna stub) may include the conductive sheet, for example, a copper sheet. In an embodiment, the sheet-like radiator (or antenna stub) may include the conductive coating, for example, silver paste. The sheet-like radiator may be in a circular shape, a rectangular shape, a ring shape, or the like. A specific shape is not limited in this application. A structure of the microstrip antenna generally includes a dielectric substrate, a radiator (or an antenna stub), and a ground plane. The dielectric substrate is disposed between the radiator (or antenna stub) and the ground plane.

The radiator (or antenna stub) may also include a slot or a slit formed on a conductor, for example, a closed or semi-closed slot or slit formed on a grounded conductor surface. In an embodiment, a radiator with a slot or a slit may be referred to as a slot antenna or a slit antenna for short. In an embodiment, a radial size (for example, including a width) of the slot or the slit of the slot antenna/slit antenna is far less than a wavelength (for example, a dielectric wavelength) (for example, less than 1/16 of the wavelength), and a length size of the slot or the slit of the slot antenna/slit antenna may be compared with the wavelength (for example, the dielectric wavelength) (for example, a length is approximately 1/8 of the wavelength, or 1/8 to 1/4 of the wavelength, or 1/4 to 1/2 of the wavelength, or greater). In an embodiment, a radiator with a closed slot or slit may be referred to as a closed slot antenna for short. In an embodiment, a radiator with a semi-closed slot or slit (for example, an opening is added on a closed slot or slit) may be referred to as an open slot antenna for short. In some embodiments, the slit is long bar-shaped. In some embodiments, a length of the slit is approximately half of the wavelength (for example, the dielectric wavelength). In some embodiments, the length of the slit is approximately an integer multiple of the wavelength (for example, a one-fold dielectric wavelength). In some embodiments, the slit may be used for feeding through a transmission line bridged on one side or two sides of the slit. In this way, a radio frequency electromagnetic field is excited on the slit, and radiates an electromagnetic wave to the space. In an embodiment, a radiator of the slot antenna or the slit antenna may be implemented by a conductive side frame whose two ends are grounded, and may also be referred to as a side frame antenna. In this embodiment, it may be considered that the slot antenna or the slit antenna includes a linear radiator, and the linear radiator is spaced apart from a ground plane and is grounded at two ends of the radiator, to form a closed or semi-closed slot or slit. In an embodiment, the radiator of the slot antenna or the slit antenna may be implemented by a bracketed conductor whose two ends are grounded, and may also be referred to as a bracketed antenna.

A feeding source/feeding circuit is a combination of all circuits configured to receive and transmit radio frequency signals. The feeding circuit may include a transceiver (transceiver) and a radio frequency front end (RF front end) circuit. In some cases, the "feeding circuit" is a radio frequency integrated circuit (RFIC, Radio Frequency Integrated Circuit) in a narrow sense, and the RFIC may be considered as including a radio frequency front end chip and a transceiver. The feeding circuit has a function of converting a radio wave (for example, a radio frequency signal) and an electrical signal (for example, a digital signal). Usually, the feeding circuit is considered as a part of radio frequency.

The terms "first" and "second" are merely intended for a purpose of description, and shall not be understood as an indication or implication of relative importance or an implicit indication of a quantity of indicated technical features. Therefore, a feature defined by "first", "second", or the like may explicitly or implicitly include one or more features.

The following describes possible implementations of this application with reference to the accompanying drawings in the possible implementations of this application.

A specific embodiment of this application provides a terminal device. The terminal device includes a display module and an antenna. The antenna includes a radiator. A circuit board is disposed in the terminal device. The circuit board has a radio frequency chip and a feeding structure electrically connected to the radio frequency chip. The radiator is electrically connected to the feeding structure, and the radiator is excited to generate a current, resulting in resonance. The radiator of the antenna is located on a periphery of a side edge of the display module.

In an implementation, the radiator is located on a side frame of the terminal device. To ensure a high screen-to-body ratio of the terminal device, a distance between the side edge of the display module and the radiator needs to be set within a preset range. In other words, the side edge of the display module cannot be too far away from the radiator. If the display module is far away from the radiator, there is a large-sized side frame on a periphery of a display screen of the terminal device, and a screen-to-body ratio is small, affecting an appearance of the terminal device and causing poor customer experience. When a high screen-to-body ratio of the display module of the terminal device is ensured, the display module absorbs some signals of the radiator of the antenna, causing an absorption loss of the display module on the antenna, and affecting performance of the antenna. Specifically, because a conductive material inside the display module is mainly ITO (indium tin oxide) with low conductivity and a thin (about 2 µm) cabling, ITO causes an absorption loss on an electromagnetic wave signal radiated by the radiator of the antenna.

To implement a high screen-to-body ratio and reduce an absorption loss of the display module on the antenna is a problem to be resolved in this application. In this application, a structure of the display module is improved, so that the absorption loss of the display module on the antenna can be reduced. This application includes at least the following three specific implementations.

In a first implementation, in this embodiment of this application, a shielding structure is disposed at a bottom and a side edge of a display structure of the display module. The shielding structure located on the side edge is used to isolate the radiator of the antenna from the display structure, to reduce signal coupling between the display structure and the radiator of the antenna, thereby reducing an absorption loss of the display module on the antenna. The shielding structure located at the bottom can also be used to isolate the display structure from some antennas at the bottom of the display structure, to reduce signal coupling, thereby reducing the absorption loss of the display module on the antenna.

In a second implementation, in this embodiment of this application, an edge of a touch layer of the display structure in the display module is inwardly retracted, so that a metal area of the touch layer is less than a metal area of a display layer. This reduces absorption of the display module to antenna radiation without affecting touch experience.

In a third implementation, in this embodiment of this application, a screen wall is manufactured at an edge structure of the display structure in a manufacturing and packaging process of the display module. From a perspective of a structure, the screen wall is built in the display structure, and is located on a periphery of a main structure of the display structure. The main structure includes a functional layer such as a conductive layer. The shielding wall is formed to reduce an absorption loss of the main structure of the display module on the antenna.

The following describes possible implementations of this application with reference to the accompanying drawings in the possible implementations of this application.

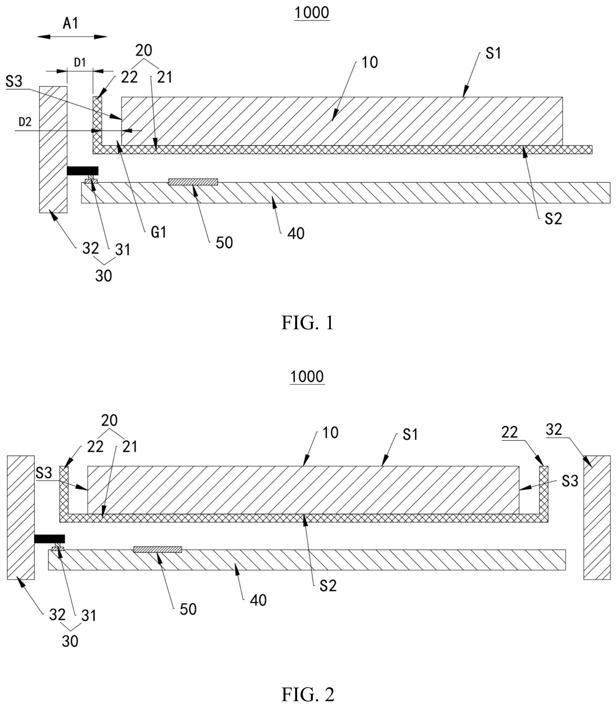

FIG. 1 is a partial diagram of a terminal device according to an implementation of this application. Refer to FIG. 1. A terminal device 1000 includes a display structure 10, a shielding structure 20, an antenna 30, and a circuit board 40.

Refer to FIG. 1. In an implementation, the display structure 10 is a display screen having a display function, and the display structure 10 has a conductive material. The conductive material may be but is not limited to ITO (indium tin oxide). For example, the display structure 10 has a circuit wiring, a pixel circuit, and the like, and these circuits are formed by the conductive material. The conductive material has characteristics of low conductivity and a thin cabling. For example, the conductivity of the conductive material may be 10^3 S/m. The conductive material causes an absorption loss on radiation of an antenna. In an implementation, the display structure 10 may include a display layer (for example, an OLED (Organic Light-Emitting Diode, organic light-emitting diode layer)) and a touch layer. The display structure 10 includes a first surface S1 and a second surface S2 that are disposed opposite to each other. At least a part of the first surface S1 forms a display surface of a screen of the terminal device 1000, and the first surface S1 faces an external part of the terminal device 1000 and is configured to provide a display interface. The second surface S2 may be understood as a back surface of the display structure 10, and the second surface S2 faces an internal part and a rear cover of the terminal device 1000 (the rear cover is not shown in FIG. 1, and the rear cover is located on a side that is of the circuit board 40 and that is away from the display structure 10). The rear cover is a part of a housing that is of the terminal device and that is opposite to the display screen. The display structure 10 further includes a side surface S3, and an orientation of the side surface S3 differs from that of the first surface S1. In a specific implementation, the side surface S3 may face a side frame of the terminal device 1000 (a radiator 32 in FIG. 1 is at least a part of the side frame), and the side surface S3 may be connected between the first surface S1 and the second surface S2.

Refer to FIG. 1. The shielding structure 20 includes a conductive material. In an implementation, the conductive material of the shielding structure 20 may be at least one of stainless steel, copper, silver paste, or conductive fabric, or a combination of at least two thereof. For example, conductivity of the conductive material in the shielding structure 20 may be 10^7 S/m. The shielding structure 20 includes a first part 21 and a second part 22. The first part 21 is connected to the second surface S2 and covers at least a part of the second surface S2. The second part 22 is located on a periphery of the side surface S3 and directly faces at least a part of the side surface S3. The first part 21 may be directly attached to the second surface S2, or another layer structure may be disposed between the first part 21 and the second surface S2, to indirectly attach the first part 21 to the second surface S2. In an implementation, the second part 22 may be connected to an edge of the first part 21, and the second part 22 and the first part 21 are interconnected to form an integrated structure, so that the shielding structure 20 forms an integrated film structure or plate structure with a bent edge.

In another implementation, the second part 22 may alternatively be independent of the first part 21, that is, the second part 22 is not connected to the first part 21. For example, both the first part 21 and the second part 22 are adhered to a surface of the display structure 10; or the first part 21 is adhered to a surface of the display structure 10, and the second part 22 is connected to another structure or a support (for example, a middle frame) in the terminal device and extends to a periphery of the side surface S3 of the display structure 10.

Refer to FIG. 1. The second part 22 is spaced from the side surface S3, and a gap G1 is formed between the second part 22 and the side surface S3. In an implementation, the shielding structure 20 and the display structure 10 are independent of each other, but the shielding structure 20 and the display structure 10 are assembled as a whole. In an assembly process, the first part 21 of the shielding structure 20 is attached to the second surface S2, so that the second part 22 is spaced from and directly faces the side surface S3. A design in which the gap G1 is maintained between the second part 22 and the side surface S3 helps prevent the second part 22 from colliding or scratching the side surface S3 of the display structure 10 in a process of assembling the shielding structure 20 to the display structure 10, and protects safety of the side surface S3 of the display structure 10. The gap G1 (a spacing distance in a direction perpendicular to the side surface) between the second part 22 and the side surface S3 needs to be greater than or equal to a preset value, for example, the preset value is 0.1 mm. The preset value is a minimum value of the gap between the second part 22 and the side surface S3, and the preset value may be set based on a tolerance range of a specific assembly process. When an assembly device has high precision, the preset value may be as small as possible. Because the gap G1 between the second part 22 and the side surface S3 is greater than or equal to the preset value, the gap G1 may be used to absorb an assembly tolerance or an operation error caused by an assembly process, to avoid collision or scratching between the second part 22 and the side surface S3 of the display structure 10, protect the display structure 10, and reduce a risk of crack generation at an edge.

Refer to FIG. 1. The antenna 30 includes a feeding circuit 31 and the radiator 32. The feeding circuit 31 is disposed on the circuit board 40. A radio frequency chip 50 may be further disposed on the circuit board 40. The feeding circuit 31 is electrically connected to the radio frequency chip 50. In an implementation, the feeding circuit 31 and the radio frequency chip 50 may be disposed on a same circuit board 40. In an implementation, the feeding circuit 31 and the radio frequency chip 50 may alternatively be located on different circuit boards. For example, the radio frequency chip 50 is disposed on a mainboard of the terminal device, the feeding circuit 31 is located on a small board in the terminal device, and the mainboard and the small board are separately disposed at different positions in the terminal device. The radiator 32 is located on the periphery of the side surface S3 of the display structure 10. In an implementation, the radiator 32 is at least a part of the side frame of the terminal device 1000. The radiator 32 is electrically connected to the feeding circuit 31. For example, the radiator 32 may be electrically connected to the feeding circuit 31 through a conductive spring.

In the implementation shown in FIG. 1, the radiator 32 is located in a partial region of a periphery of the display structure 10, the second part 22 is also located in the partial region of the periphery of the display structure 10, and the second part 22 is located between the radiator 32 and the side surface S3 of the display structure 10. The second part 22 is configured to: isolate at least a part of a signal between the display structure 10 and the radiator 32, reduce signal coupling between the display structure 10 and the radiator 32, and reduce an absorption loss of the display structure 10 on the antenna 30.

In an implementation, in the direction perpendicular to the side surface S3 of the display structure 10 (that is, a first direction A1), or in a radial direction of a display surface of the display structure 10 (a direction radiated from a center to a periphery, that is, the first direction A1), a vertical distance D1 between the second part 22 and the radiator 32 is greater than or equal to 0.3 mm and less than or equal to 3.3 mm; and a vertical distance D2 between the second part 22 and the side surface S3 of the display structure 10 is greater than or equal to a preset value (for example, greater than or equal to 0.1 mm) and less than or equal to 0.3 mm. In this solution, the second part 22 of the shielding structure 20 is close to the side surface S3 of the display structure 10, so that it can be ensured that a proper distance is maintained between the shielding structure 20 and the radiator 32, to reduce impact of the second part 22 on clearance of the radiator 32. Because the shielding structure 20 includes the conductive material, the shielding structure 20 is a conductor structure, and disposing the shielding structure 20 around the radiator 32 affects the clearance of the radiator 32, and affects performance of receiving and sending a signal by the antenna 30. Therefore, it needs to be ensured that a distance between the second part 22 and the radiator 32 falls within a proper range, so that a degree of impact of the second part 22 on the radiator 32 is less than a gain brought by reducing an absorption loss of the display structure 10 on the antenna 30 by using the second part 22. In this way, even if the second part 22 affects the clearance, overall performance of the antenna 30 can be improved in this application due to a larger gain generated by isolating signal coupling between the display structure 10 and the radiator 32.

FIG. 2 is a partial diagram of a terminal device according to an implementation of this application. A difference between the implementation shown in FIG. 2 and the implementation shown in FIG. 1 lies in that, in the implementation shown in FIG. 2, the radiator 32 is distributed on an outer side of the display structure 10, there are radiators 32 on two sides of the display structure 10, the radiators 32 on the two sides of the display structure 10 in FIG. 2 are interconnected into an integrated structure, and second parts 22 on peripheries of side surfaces S3 of the opposite two sides of the display structure 10 are interconnected into an integrated structure. It may be understood that, in this implementation, the radiator 32 at least semi-encloses the display structure 10, or the radiators 32 may completely enclose the display structure 10. Correspondingly, the second part 22 also at least semi-encloses the side surface S3 of the display structure 10, or the second parts 22 may completely enclose the side surfaces S3 of the display structure 10.

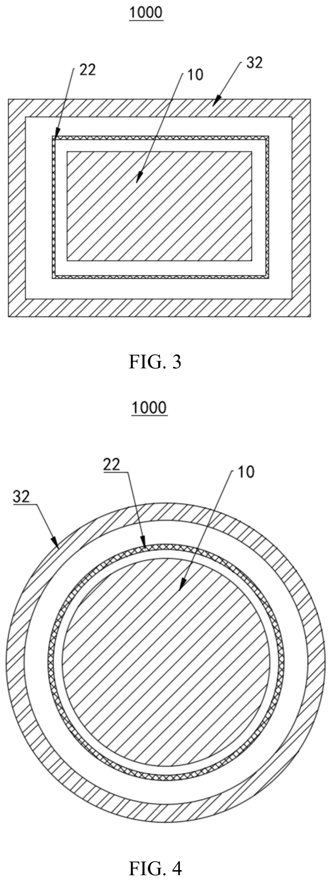

FIG. 3 is a diagram of a plane in which a display screen of a terminal device 1000 is located according to an implementation of this application. Refer to FIG. 3. In an implementation, the display screen of the terminal device 1000 is rectangular, and the terminal device 1000 may be a watch, or may be another terminal such as a mobile phone or a tablet. The display structure 10 is rectangular, the second part 22 is a rectangular frame and surrounds the periphery of the display structure 10, and the radiator 32 is a rectangular frame and surrounds a periphery of the second part 22.

FIG. 4 is a diagram of a plane in which a display screen of a terminal device 1000 is located according to an implementation of this application. Refer to FIG. 4. In an implementation, the display screen of the terminal device 1000 is circular. The display structure 10 is circular, the second part 22 is a ring and surrounds the periphery of the display structure 10, and the radiator 32 is a ring and surrounds a periphery of the second part 22.

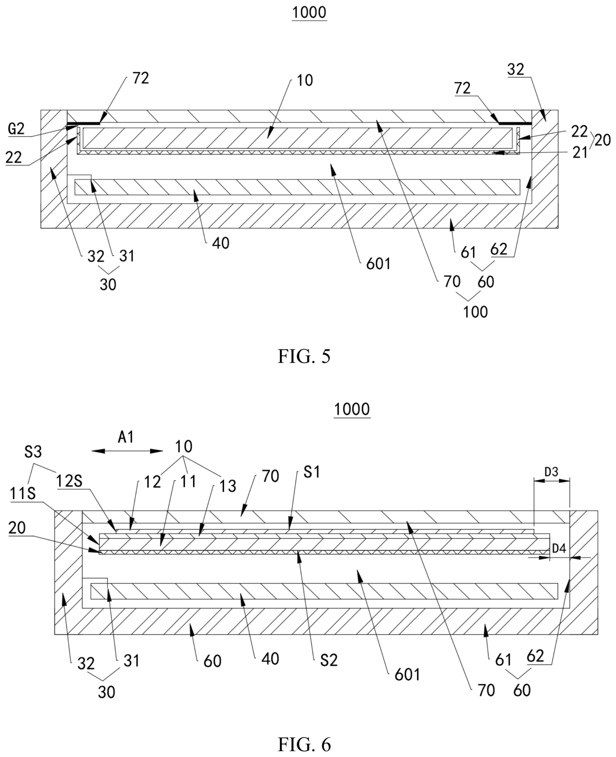

FIG. 5 is a diagram of a terminal device 1000 according to an implementation of this application. Refer to FIG. 5. The terminal device 1000 includes a housing 100, the housing 100 includes a housing body 60 and a cover 70, the housing body 60 encloses an accommodation space 601 with an opening, and the cover 70 is located at the opening of the accommodation space 601 and is connected to the housing body 60. In an implementation, the cover 70 is made of a transparent material, for example, glass or sapphire. The housing body 60 includes a side frame 62 and a rear cover 61. The rear cover 61 and the cover 70 are disposed opposite to each other. The side frame 62 surrounds edge peripheries of the rear cover 61 and the cover 70. The side frame 62 is configured to dispose the radiator 32 of the antenna 30 in the terminal device 1000. It may also be understood as that the side frame 62 forms the radiator 32 of the antenna 30. The display structure 10, the shielding structure 20, and the circuit board 40 of the terminal device 1000 are disposed in the accommodation space 601. The display structure 10 is located on an inner side of the cover 70, and the circuit board 40 is located between the display structure 10 and the rear cover 61. In this implementation, the first part 21 of the shielding structure 20 is located at the bottom of the display structure 10, the first part 21 is located between the circuit board 40 and the display structure 10, and the first part 21 can reduce a loss caused by signal absorption of the display structure 10 on a radio frequency line on the circuit board 40. The second part 22 of the shielding structure 20 surrounds the periphery of the side surface S3 of the display structure 10, and the second part 22 can reduce a loss caused by signal absorption of the display structure 10 on the radiator 32.

In the implementation shown in FIG. 5, the display structure 10 may be pasted to the cover 70 by using an optical adhesive, and an optical film, for example, a light filter or a polarizer, may alternatively be disposed between the display structure 10 and the cover 70. An inner surface of the cover 70 has an ink layer 72, and the ink layer 72 is configured to block a line at an edge of the display structure 10. There is a gap G2 between the second part 22 and the ink layer 72. The gap G2 between the second part 22 and the ink layer 72 can prevent the second part 22 from contacting the ink layer 72, and prevent the second part 22 from scratching the ink layer 72.

FIG. 6 is a diagram of a terminal device according to an implementation of this application. Refer to FIG. 6. A terminal device 1000 includes a display structure 10, an antenna 30, and a circuit board 40. The display structure 10 includes a first surface S1 and a second surface S2 that are disposed opposite to each other, and a side surface S3 connected between the first surface S1 and the second surface S2. At least a part of the first surface S1 forms a display surface of a screen of the terminal device 1000. In an implementation, the terminal device 1000 further includes a shielding structure 20, and the shielding structure 20 includes a conductive material. The shielding structure 20 is disposed on a side of the second surface S2 of the display structure 10, the circuit board 40 is located below the second surface S2 of the display structure 10, and the shielding structure 20 is located between the second surface S2 of the display structure 10 and the circuit board 40. The antenna 30 includes a feeding circuit 31 and a radiator 32. The feeding circuit 31 is disposed on the circuit board 40, and the radiator 32 is disposed around a periphery of the side surface S3 of the display structure 10. The shielding structure 20 is configured to: reduce signal coupling between the display structure 10 and the feeding circuit 31 of the antenna 30, and reduce an absorption loss of the display structure 10 on the antenna.

Refer to FIG. 6. The display structure 10 includes a display layer 11 and a touch layer 12 that are stacked, and an edge of the touch layer 12 is inwardly retracted relative to an edge of the display layer 11. A side surface 11S of the display layer 11 and a side surface 12S of the touch layer 12 separately form a part of the side surface S3 of the display structure 10. In a direction perpendicular to the side surface S3 (that is, a first direction A1), a vertical distance D3 between the radiator 32 and the edge of the touch layer 12 is greater than a vertical distance D4 between the radiator 32 and the edge of the display layer 11. For the display structure 10, a touch function is seldom applied in an edge region. Therefore, the edge of the touch layer 12 is inwardly retracted relative to the display layer 11, and a retracted size is maintained within a proper range, so that the touch function of the display structure 10 is not affected. The edge of the touch layer 12 is inwardly retracted, so that a spacing distance between a line in the touch layer 12 and the radiator 32 is increased, thereby reducing an absorption loss of the touch layer 12 on the radiator 32. Therefore, in this solution, the edge of the touch layer 12 is inwardly retracted relative to the edge of the display layer 11, so that signal coupling between the display structure 10 and the radiator 32 can be reduced while ensuring that the touch function of the display structure 10 meets a use requirement, and an absorption loss of the display structure 10 on the radiator 32 can be reduced.

In this implementation, in the direction perpendicular to the side surface S3, a size of the vertical distance D3 between the edge of the touch layer 12 and the radiator 32 ranges from 0.9 mm to 4.6 mm, and a size of the vertical distance D4 between the edge of the display layer 11 and the radiator 32 ranges from 0.4 mm to 4.1 mm. In an implementation, a size (D3-D4) of the edge that is of the touch layer 12 and that is inwardly retracted relative to the edge of the display layer 11 ranges from 0.5 mm to 1 mm.

In the implementation shown in FIG. 6, the touch layer 12 is inwardly retracted relative to the display layer 11, so that an absorption loss of the display structure 10 on the radiator 32 is reduced. In this implementation, the touch layer 12 and the display layer 11 are two independent layer structures, and there may be a spacing layer structure 13 between the touch layer 12 and the display layer 11. For example, the touch layer 12 and the display layer 11 are spaced by at least 0.3 mm, that is, a thickness of the spacing layer structure 13 is at least 0.3 mm.

In the implementation shown in FIG. 6, the radiator 32 may be a side frame 62 or a part of the side frame 62 of the housing body 60 of the terminal device 1000. The terminal device 1000 may further include a cover 70. The cover 70 and the housing body 60 are connected to jointly enclose an accommodation space 601. The display structure 10 and the circuit board 40 are located in the accommodation space 601. The first surface S1 of the display structure 10 faces the cover 70. In an implementation, the first surface S1 may be pasted to the cover 70 by using an optical adhesive. In an implementation, an optical film, for example, a light filter or a polarizer, may alternatively be disposed between the first surface S1 and the cover 70.

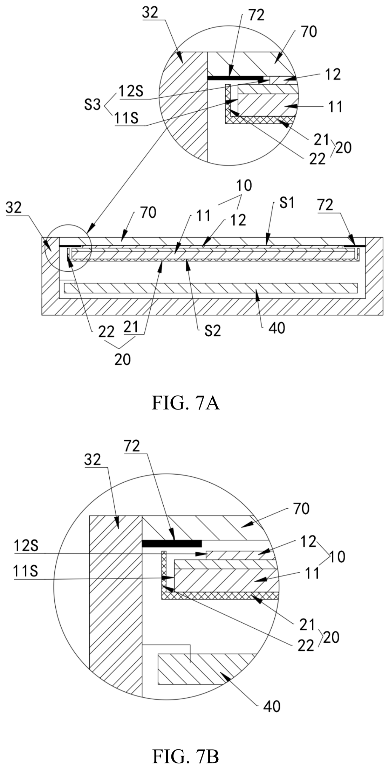

FIG. 7A is a diagram of a terminal device according to an implementation of this application. In the implementation shown in FIG. 7A, based on the implementation shown in FIG. 6, a part of a shielding structure 20 is added on a periphery of a side surface S3 of a display structure 10, to better reduce an absorption loss of the display structure 10 on a radiator 32. Refer to FIG. 7A. The shielding structure 20 includes a first part 21 and a second part 22. The display structure 10 includes a first surface S1 and a second surface S2 that are disposed opposite to each other, and the side surface S3 connected between the first surface S1 and the second surface S2. The first surface S1 faces a cover 70, and the first surface S1 may be attached to an inner surface of the cover 70. The first part 21 is connected to the second surface S2 of the display structure 10, and covers at least a part of the second surface S2. The second part 22 is located on the periphery of the side surface S3 of the display structure 10 and is spaced from and directly faces the side surface S3. In a specific implementation, an edge of the first part 21 is located on a periphery of an edge of the display structure 10, and a projection of the display structure 10 on the first part 21 is located inside the first part 21. An opening or a hollow region may be disposed on the first part 21, to provide clearance for other components in the terminal device through the opening or the hollow region. The second part 22 bends and extends from an edge of the first part 21 and blocks at least a part of the side surface S3 of the display structure 10.

Refer to FIG. 7A. The side surface S3 of the display structure 10 includes a side surface 11S of a display layer 11, a side surface 12S of a touch layer 12, and a part connected between the side surface 11S of the display layer 11 and the side surface 12S of the touch layer 12. In an implementation, the second part 22 directly faces the side surface 11S of the display layer 11 of the display structure 10. One end that is of the second part 22 and that is away from the first part 21 may be flush with a surface that is of the display layer 11 and that is away from the first part 21. A vertical distance between the end that is of the second part 22 and that is away from the first part 21 and the first part 21 may be greater than a thickness of the display layer 11, that is, in a direction perpendicular to the side surface 11S of the display layer 11, a vertical projection of the display layer 11 on the second part 22 is located inside the second part 22. In this solution, the touch layer 12 may be attached to the inner surface of the cover 70 of the terminal device 1000, or the touch layer 12 is integrated with the inner surface of the cover 70, to ensure that a gap is maintained between the second part 22 and the inner surface of the cover 70, and prevent the second part 22 from scratching an ink layer 72 on the inner surface of the cover 70. In this solution, a periphery of the side surface 12S of the touch layer 12 is the ink layer 72, and the second part 22 does not extend to the periphery of the side surface 12S of the touch layer 12. A design in which the touch layer 12 is attached to or integrated with the inner surface of the cover 70 helps implement a light and thin design of the terminal device 1000 in this solution.

In this solution, the second part 22 may also block the side surface 11S of the display layer 11 on the periphery of the side surface S3 of the display structure 10, and the edge of the touch layer 12 is inwardly retracted relative to the edge of the display layer 11, to reduce signal coupling between the display structure 10 and the radiator 32, and reduce an absorption loss of the display structure 10 on the radiator 32.

FIG. 7B is a partially enlarged diagram of a terminal device according to an implementation of this application. Refer to FIG. 7B. In an implementation, the touch layer 12 is spaced from the cover 70, the second part 22 may also directly face the side surface 11S of the display layer 11 and the side surface 12S of the touch layer 12, and a gap is maintained between the second part 22 and the ink layer 72 on the inner surface of the cover 70. In this solution, a vertical distance between a surface that is of the touch layer 12 and that is away from the display layer 11 and the first part 21 is equal to a height by which a top of the second part 22 protrudes relative to the first part 21, and the top of the second part 22 is an end that is of the second part 22 and that is away from the first part 21. In this implementation, the second part 22 of the shielding structure 20 is flush with the surface that is of the touch layer 12 and that is away from the display layer 11, so that the second part 22 blocks the display layer 11 and the touch layer 12. With reference to a design in which the edge of the touch layer 12 is inwardly retracted relative to the edge of the display layer 11, signal coupling between the display structure 10 and the radiator 32 is reduced, thereby reducing an absorption loss of the display structure 10 on the radiator 32.

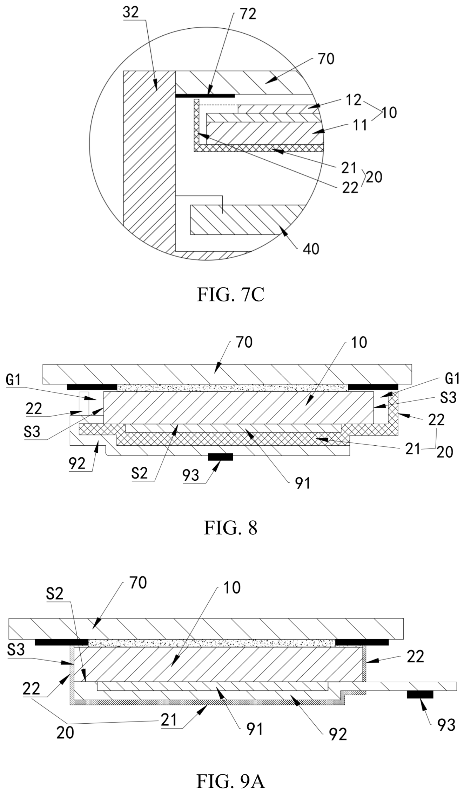

FIG. 7C is a partially enlarged diagram of a terminal device according to an implementation of this application. Refer to FIG. 7C. In the implementation shown in FIG. 7C, based on the implementation shown in FIG. 7B, a spacing distance between the touch layer 12 and the cover 70 is increased, and in a direction perpendicular to the first part 21 of the shielding structure 20, a height of one end that is of the second part 22 and that is away from the first part 21 exceeds the surface that is of the touch layer 12 and that is away from the display layer 11. It can be seen from a dashed line extending from an edge of the touch layer 12 in FIG. 7C that a top surface of the touch layer 12 is inside the second part 22, and a part that is of the second part 22 and that is above the dashed line is a part that is of the second part 22 and that exceeds the touch layer 12. A gap is still maintained between the end that is of the second part 22 and that is away from the first part 21 and the ink layer 72 on the inner surface of the cover 70. In this solution, a vertical distance between the surface that is of the touch layer 12 and that is away from the display layer 11 and the first part 21 is less than the height by which the top of the second part 22 protrudes relative to the first part 21, and the top of the second part 22 is the end that is of the second part 22 and that is away from the first part 21. The height of the part that is of the second part 22 and that exceeds a surface of the touch layer 12 can be used to reduce signal coupling between the display structure 10 and the radiator 32, and reduce an absorption loss of the display structure 10 on the radiator 32. In the implementations shown in FIG. 7B and FIG. 7C, the edge of the touch layer 12 may not be inwardly retracted, that is, the edge of the touch layer 12 may be flush with the edge of the display layer 11.

FIG. 8 is a diagram of a specific structural design between a display structure and a shielding structure that are in a terminal device according to an implementation of this application. Refer to FIG. 8. The shielding structure 20 is a shielding can structure with a bent edge, the shielding structure 20 is independent of the display structure 10, and there is a gap G1 between the second part 22 of the shielding structure 20 and the side surface S3 of the display structure 10. In this implementation, the terminal device further includes a near field communication antenna 91, the near field communication antenna 91 is attached to the second surface S2 of the display structure 10, and the first part 21 of the shielding structure 20 is attached to the second surface S2, so that the near field communication antenna 91 is sandwiched between the first part 21 and the second surface S2. The terminal device further includes an FPC (or a conductive flat cable) 92 connected to the display structure 10. The FPC (or the conductive flat cable) 92 is led out from an edge position of the first part 21, that is, an opening position formed by the second part 22, and the FPC (or the conductive flat cable) 92 is stacked on a surface that is of the first part 21 and that is away from the display structure 10. The FPC (or the conductive flat cable) has a connector 93, and the connector 93 is configured to be electrically connected to another control chip, a system-on-chip, or a connector on a mainboard in the terminal device. Specifically, the connector 93 may be a BTB connector. In this solution, the display structure 10 is attached to the cover 70 (a protective layer, for example, glass or sapphire) of the terminal device by using an optical adhesive, an edge of the cover 70 exceeds an edge of the display structure, and there is a gap between the second part 22 and the ink layer on the inner surface of the cover 70.

FIG. 9A is a diagram of a specific structural design between a display structure and a shielding structure that are in a terminal device according to an implementation of this application. Refer to FIG. 9A. The shielding structure 20 is sprayed on the second surface S2 and the side surface S3 of the display structure 10 by spraying a metal material. In this implementation, the second part 22 of the shielding structure 20 is attached to the side surface S3 of the display structure 10. Specifically, the metal material sprayed on the side surface S3 forms the second part 22 of the shielding structure 20. In this solution, the display structure 10 is attached to the cover 70 (a protective layer, for example, glass or sapphire) of the terminal device by using an optical adhesive, an edge of the cover 70 exceeds an edge of the display structure 10, and the top of the second part 22 is connected to the inner surface of the cover 70. In this solution, the shielding structure 20 and the cover 70 jointly surround the display structure 10, so that the display structure 10 can be completely enclosed. This is more conducive to reducing an absorption loss caused by the display structure 10 to the antenna radiator. In another implementation, the second part 22 may alternatively cover a partial area of the side surface S3, and a gap may also be formed between the second part 22 and the inner surface of the cover 70.

In the implementation shown in FIG. 9A, the terminal device further includes a near field communication (NFC) antenna 91, and the near field communication (NFC) antenna 91 is attached to the second surface S2 of the display structure 10. The terminal device further includes an FPC (or a conductive flat cable) 92 connected to the display structure 10. The FPC (or the conductive flat cable) 92 is attached to the second surface S2 and covers the near field communication (NFC) antenna 91, so that the near field communication (NFC) antenna 91 is sandwiched between the second surface S2 and the FPC (or the conductive flat cable) 92. The first part 21 of the shielding structure 20 is sprayed on an outer surface of the FPC. A part of the FPC (or the conductive flat cable) 92 extends to the outside of the edge of the display structure 10, and a connector 93 is disposed on the part that is of the FPC (or the conductive flat cable) 92 and that extends to the outside.

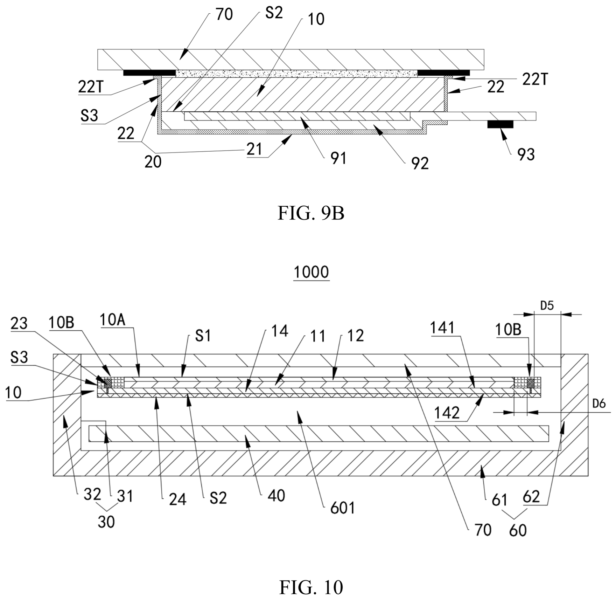

FIG. 9B is a diagram of a specific structural design between a display structure and a shielding structure that are in a terminal device according to an implementation of this application. A difference between the implementation shown in FIG. 9B and the implementation shown in FIG. 9A lies in that, in the implementation shown in FIG. 9B, a bent part 22T is formed at a joint between the second part 22 of the shielding structure 20 and the cover 70, the bent part 22T covers the inner surface of the cover, the bent part 22T surrounds the periphery of the display structure 10 to form an annular architecture, and a width of the bent part 22T in a radial direction may be controlled within 0.2 mm, to ensure good clearance of the antenna.

FIG. 10 is a diagram of a terminal device according to an implementation of this application. Refer to FIG. 10. A terminal device 1000 includes a display structure 10 and an antenna 30. The antenna 30 includes a feeding circuit 31 and a radiator 32. The radiator 32 of the antenna 30 is located on a side frame 62 of a housing body 60 of the terminal device 1000. The display structure 10 includes a first surface S1 and a second surface S2 that are disposed opposite to each other, and a side surface S3 connected between the first surface S1 and the second surface S2. At least a part of the first surface S1 is a display surface of a screen of the terminal device 1000. The first surface S1 faces a cover 70 of the terminal device 1000. The cover 70 is connected to an opening position of the housing body 60, and the housing body 60 and the cover 70 jointly enclose an accommodation space 601. The display structure 10 and a circuit board 40 are located in the accommodation space 601, and the feeding circuit 31 is located on the circuit board 40.

In an implementation, the display structure 10 includes a substrate 14, a main structure 10A, and an edge structure 10B, the substrate 14 includes a top surface 141 and a bottom surface 142 that are disposed opposite to each other, the main structure 10A and the edge structure 10B are formed on the top surface 141 of the substrate 14, and the edge structure 10B is disposed around a periphery of at least a part of the main structure 10A. The main structure 10A and the edge structure 10B are integrally formed on the substrate 14 by using a circuit board manufacturing process. The main structure 10A includes a display layer 11 and a touch layer 12 that are stacked in a direction perpendicular to the top surface 141. The edge structure 10B includes a shielding wall 23, and in a direction perpendicular to the side surface S3, the shielding wall 23 covers at least a part of the main structure 10A.

The radiator 32 of the antenna 30 is located on a periphery of the side surface S3 and is spaced from the display structure 10. In the direction perpendicular to the side surface S3, the shielding wall 23 is located between the radiator 32 and the main structure 10A, to isolate at least a part of a signal between the radiator 32 and the main structure 10A, and a distance D5 between the radiator 32 and the shielding wall 23 is greater than a distance D6 between the shielding wall 23 and the main structure 10A. In the implementation shown in FIG. 10, a part of the main structure 10A of the display structure 10 includes a conductive line formed by a conductive material. If there is no isolation provided by the shielding wall 23, the main structure 10A easily absorbs a signal of the antenna 30, and the conductive material of the main structure 10A easily generates signal coupling with the radiator 32. As a result, the main structure 10A causes signal loss to the radiator 32 of the antenna 30. In this solution, a structure of the shielding wall 23 is formed in the display structure 10, and the shielding wall 23 includes a conductive material. The shielding wall 23 can reduce signal coupling between the radiator 32 and the main structure 10A, and reduce an absorption loss of the display structure 10 on the radiator 32.

In an implementation, the shielding wall 23 is a shielding wall 23 that is made of a conductive material on a surface of the substrate 14 by using a manufacturing process such as spraying or printing and that is formed around the main structure 10A. The conductive material of the shielding wall 23 may be silver paste and the like. In an implementation, a height of the shielding wall 23 on the substrate 14 is greater than a height of the display layer 11. In an implementation, a height of the shielding wall 23 on the substrate 14 may be flush with a height of the touch layer 12 of the main structure 10A.

Refer to FIG. 10. A radio frequency chip and a feeding circuit 31 may be disposed on the circuit board 40 inside the terminal device, and the feeding circuit 31 feeds power to the radiator 32. The display structure 10 further includes a shielding layer 24, the shielding layer 24 is located on a side of the bottom surface 142 of the substrate 14, and the shielding layer 24 covers at least a part of the main structure 10A. The shielding layer 24 is electrically connected to the shielding wall 23 through a via hole on the substrate 14. The shielding layer 24 is spaced between the circuit board 40 and the display structure 10, and the shielding layer 24 can reduce a loss caused by signal absorption of the display structure 10 on a radio frequency line on the circuit board 40.

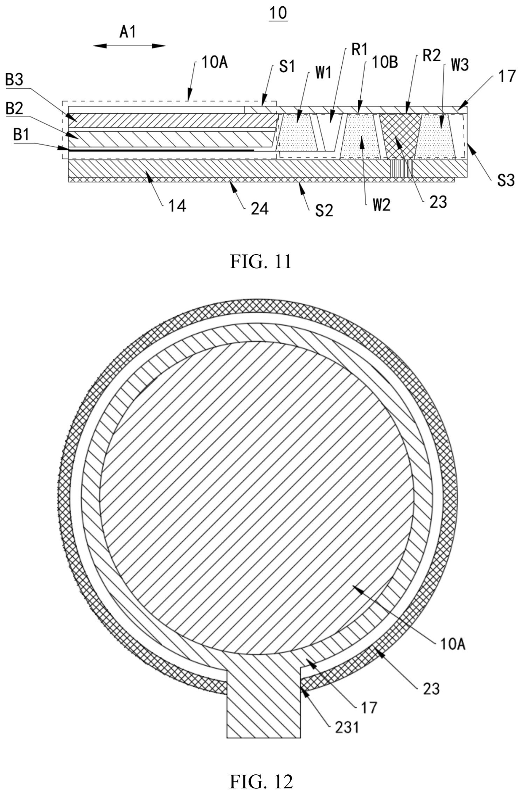

FIG. 11 is a partially enlarged diagram of a display structure according to an implementation of a terminal device shown in FIG. 10. A feature enclosed by a dashed box in FIG. 11 represents the main structure 10A and the edge structure 10B. Refer to FIG. 11. The main structure 10A includes a TFT (thin film transistor, thin film transistor) circuit B1, a TFE (thin film encapsulation, thin film encapsulation) vapor deposition layer B2, and a TOE (touch on encapsulation, touch layer on encapsulation) layer B3 that are stacked on the substrate 14. The edge structure 10B is located on a periphery of the main structure 10A.

The display structure 10 includes a first surface S1 and a second surface S2 that are disposed opposite to each other, and a side surface S3 connected between the first surface S1 and the second surface S2. The edge structure 10B includes three layers of insulation walls. In a direction perpendicular to the side surface S3 of the display structure 10, that is, a first direction A1, the three layers of insulation walls are respectively an inner wall W1, a middle wall W2, and an outer wall W3. A first spacing space R1 is formed between the inner wall W1 and the middle wall W2, and a second spacing space R2 is formed between the middle wall W2 and the outer wall W3. The first spacing space R1 is used to accommodate a conductive material overflowed from the main structure 10A in a manufacturing process, to prevent the overflowed conductive material from entering the second spacing space R2. The second spacing space R2 is filled with a conductive material, and the shielding wall 23 is formed by filling the conductive material in the second spacing space R2. The shielding wall 23 is configured to: reduce signal coupling between the radiator and the main structure 10A, and reduce an absorption loss of the display structure 10 on the radiator. The bottom of the shielding wall 23 is electrically connected to the shielding layer 24 on the bottom surface of the substrate 14 through a via hole (a conductive through hole) on the substrate 14.

Specifically, a region in which the first spacing space R1 is located forms an isolation part of the edge structure 10B, the isolation part is located between the shielding wall 23 and the main structure 10A, and an accommodation space (that is, the first spacing space R1) in the isolation part is used to accommodate a conductive material that flows from the main structure 10A to the isolation part in a process of manufacturing the main structure 10A. In a specific implementation, in the process of manufacturing the main structure 10A, a conductive material may be printed on the substrate 14 by using a manufacturing process such as spraying or printing. In the manufacturing process, the conductive material is in a liquid state and has fluidity. In this way, in this solution, the isolation part is disposed in a region between the shielding wall 23 and an edge of the main structure 10A. The isolation part is similar to a dam structure, and can prevent a conductive material from flowing to a position of the shielding wall 23.

FIG. 12 is a planar diagram of a display structure according to an implementation of a terminal device shown in FIG. 10. Refer to FIG. 12. The shielding wall 23 forms a surrounding structure with an opening 231. Refer to FIG. 11 and FIG. 12. The display structure 10 includes an edge cable 17, the edge cable 17 is stacked on a side that is of the edge structure 10B and that is away from the substrate 14, the edge cable 17 is electrically connected to the main structure 10A, and the edge cable 17 passes through the opening 231 and extends to a periphery of the edge structure 10B.

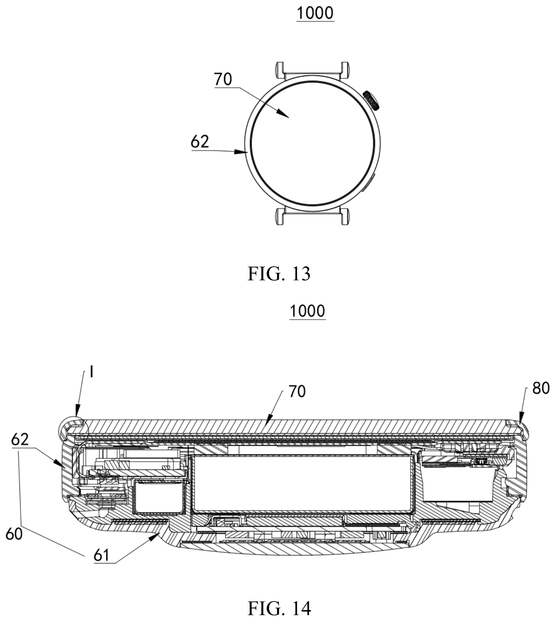

FIG. 13 is a diagram of a terminal device according to an implementation of this application. Refer to FIG. 13. A terminal device 1000 provided in this application may be a wearable device such as a watch or a smart band. The terminal device 1000 has a cover 70 with a display screen and a side frame 62. The side frame 62 is configured to dispose a radiator of an antenna of the terminal device 1000.

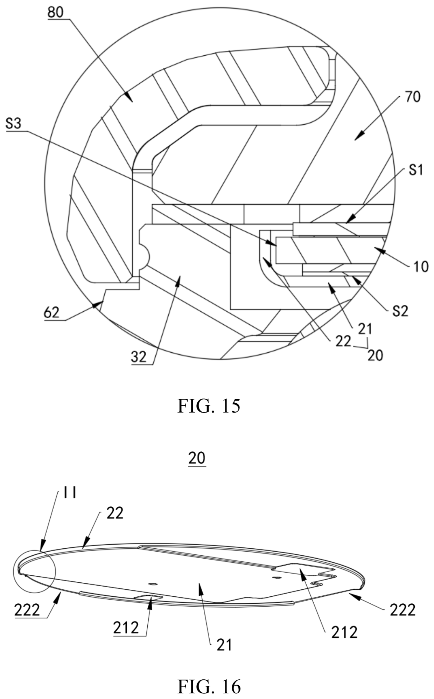

FIG. 14 is a sectional view of the terminal device shown in FIG. 13, and FIG. 15 is an enlarged diagram of a part I in FIG. 14. Refer to FIG. 14 and FIG. 15. A housing body 60 of the terminal device includes a side frame 62 and the rear cover 61. The side frame 62 and the rear cover 61 are mutually independent parts, and the side frame 62 and the rear cover 61 are assembled and connected, for example, may be fastened by using an adhesive. The side frame 62 and the rear cover 61 may alternatively be of an integrally formed structure. A top of the side frame 62 is connected to the cover 70, an edge of the cover 70 is fastened to the side frame 62, a decorative ring 80 is disposed on a periphery of a joint between the cover 70 and the side frame 62, and the decorative ring 80 blocks the joint between the cover 70 and the side frame 62. A display structure 10 is disposed on an inner side of the cover 70, a top surface of the display structure 10 is a first surface S1, a bottom surface of the display structure 10 is a second surface S2, the first surface S1 faces the inner surface of the cover 70, the second surface S2 is connected to the first part 21 of the shielding structure 20, and the second part 22 of the shielding structure 20 is bent upward from an edge of the first part 21, and blocks a periphery of the side surface S3 of the display structure 10. The second part 22 is located between the display structure 10 and the side frame 62, and the side frame 62 is the radiator 32 of the antenna. The second part 22 can isolate at least a part of signal coupling between the radiator 32 and the display structure 10, and reduce an absorption loss of the display structure 10 on the radiator 32.

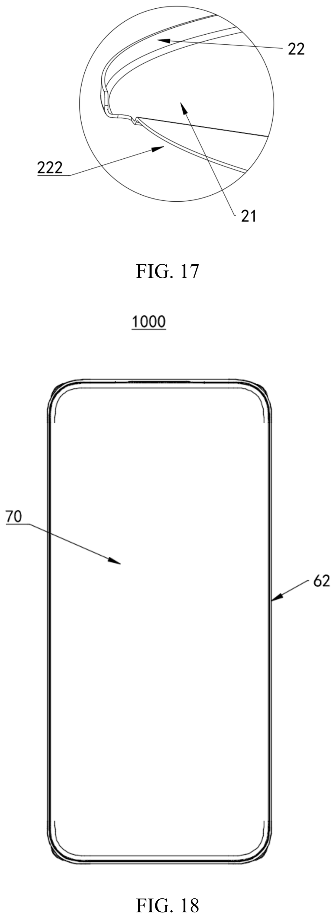

FIG. 16 is a three-dimensional diagram of a shielding structure in the terminal device shown in FIG. 13. FIG. 17 is an enlarged diagram of a part II in FIG. 16. Refer to FIG. 16. The first part 21 of the shielding structure 20 has a hollow region 212. The hollow region 212 is used to provide clearance for a component with a large size in the terminal device, for example, an ambient light sensor (ALS) or a near field communication (NFC) antenna.

Refer to FIG. 16 and FIG. 17. The second part 22 and the first part 21 are of an integrally formed structure, and the second part 22 is a bent edge formed by bending an edge of the first part 21. The second part 22 forms a structure that does not completely enclose the edge of the first part 21, and the second part 22 surrounds the edge of the first part 21 to form an opening 222. As shown in FIG. 16, the second part 22 surrounds the edge of the first part 21, to form two openings 222. For example, one of the two openings 222 is configured to provide clearance for a flexible circuit board of the display screen, and is electrically connected to a system-on-chip on a mainboard in the terminal device through the flexible circuit board. The other of the two openings 222 is configured to provide clearance for other mechanical parts in the terminal device.

FIG. 18 is a diagram of a terminal device according to an implementation of this application. Refer to FIG. 18. A terminal device 1000 provided in this application may be a mobile phone. The terminal device 1000 has a cover 70 with a display screen and a side frame 62. The side frame 62 is configured to dispose a radiator of an antenna of the terminal device 1000.

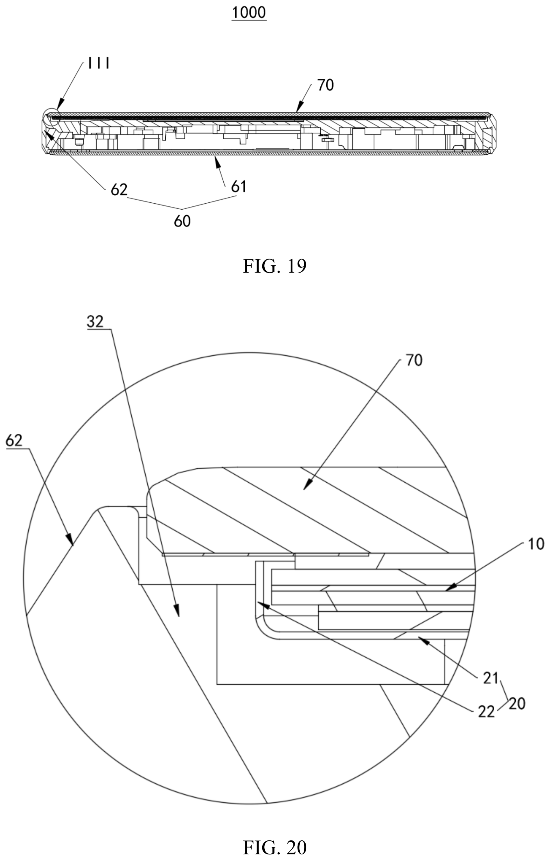

FIG. 19 is a sectional view of the terminal device shown in FIG. 18, and FIG. 20 is an enlarged diagram of a part III in FIG. 19. Refer to FIG. 19 and FIG. 20. A housing body 60 of the terminal device includes the side frame 62 and a rear cover 61. The side frame 62 and the rear cover 61 may be independent parts and assembled as a whole, or may be of an integrally formed structure. An outer layer of the display screen of the terminal device 1000 is a protective layer (namely, the cover 70), there is a display structure 10 inside the terminal device 1000, and the protective layer (namely, the cover 70) is connected to the side frame 62. The protective layer (namely, the cover 70) is stacked on a display surface of the display structure 10. Refer to FIG. 20. A bottom surface of the display structure 10 is connected to a first part 21 of a shielding structure 20, and a second part 22 of the shielding structure 20 is bent upward from an edge of the first part 21, and blocks a periphery of a side surface of the display structure 10. The second part 22 is located between the display structure 10 and the side frame 62, and the side frame 62 is the radiator 32 of the antenna. The second part 22 can isolate at least a part of signal coupling between the radiator 32 and the display structure 10, and reduce an absorption loss of the display structure 10 on the radiator 32.

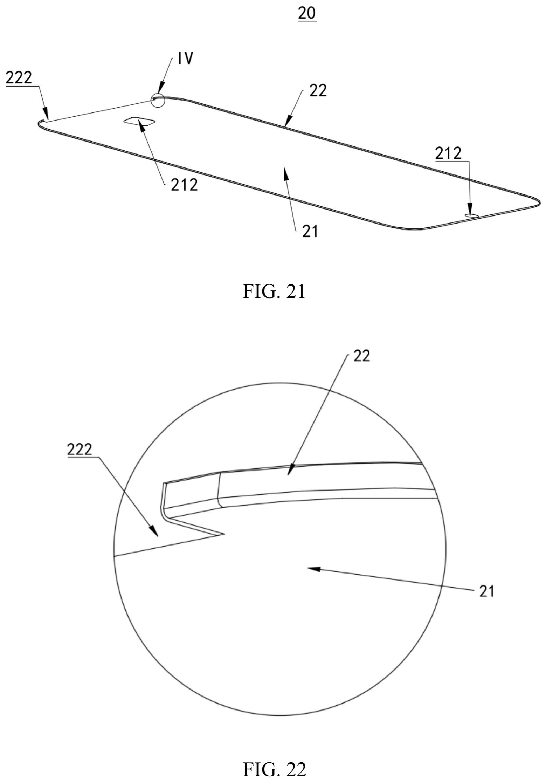

FIG. 21 is a three-dimensional diagram of a shielding structure in the terminal device shown in FIG. 18. FIG. 22 is an enlarged diagram of a part IV in FIG. 21. Refer to FIG. 21, in this implementation, the first part 21 of the shielding structure 20 has a hollow region 212, and the hollow region 212 is used to provide clearance for a component with a large size in the terminal device, for example, an ambient light sensor (ALS) or a near field communication (NFC) antenna. Refer to FIG. 21 and FIG. 22. The second part 22 and the first part 21 are of an integrally formed structure, and the second part 22 is a bent edge formed by bending an edge of the first part 21. The second part 22 forms a structure that does not completely enclose the edge of the first part 21, and the second part 22 surrounds the edge of the first part 21 to form openings 222. As shown in FIG. 21, the second part 22 surrounds the edge of the first part 21, to form one opening 222. For example, one of two openings 222 is configured to provide clearance for a flexible circuit board of the display screen, and electrically connected to a system-on-chip on a mainboard in the terminal device through the flexible circuit board. The other of the two openings 222 is configured to provide clearance for other mechanical parts in the terminal device.

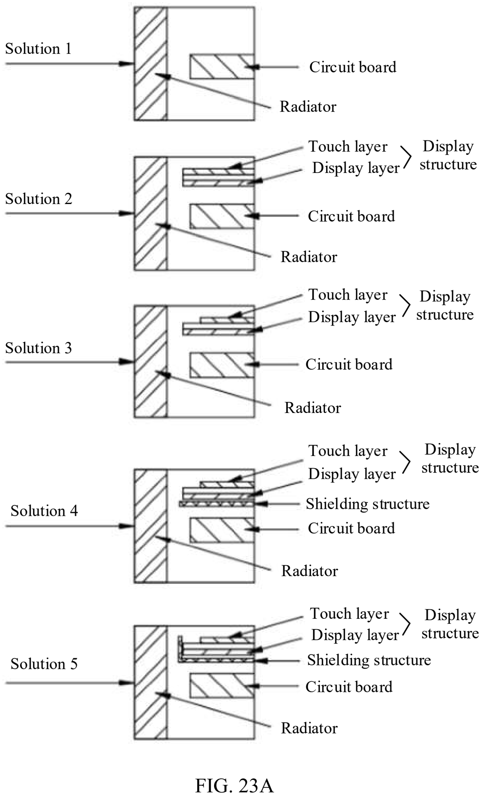

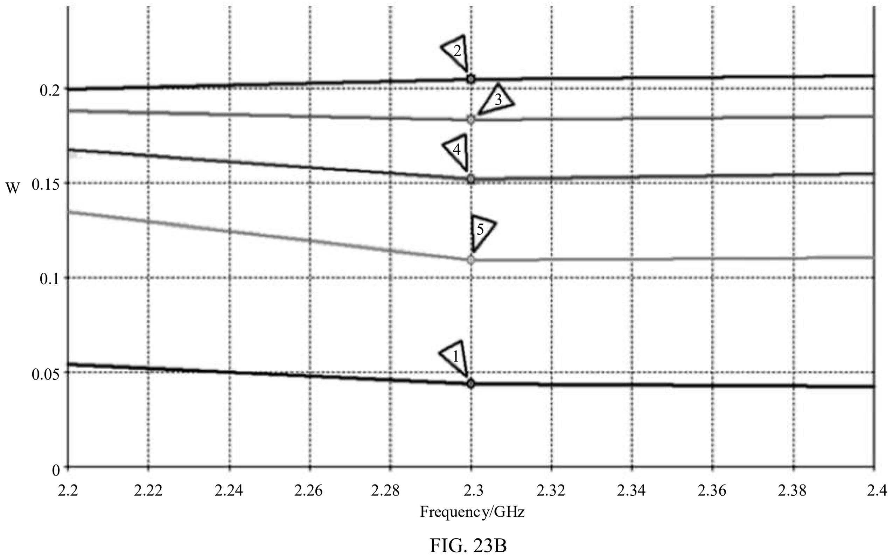

In this application, simulation tests are performed on a terminal device provided in an implementation, and the terminal device is a watch. FIG. 23A shows structures of five different test solutions. FIG. 23B shows simulated absorption-loss curves for radiators generated based on the five solutions shown in FIG. 23A.

Refer to FIG. 23A. A terminal device shown in Solution 1 includes a radiator and a circuit board. In Solution 1, no display structure is disposed in the terminal device, that is, there is no ITO material. In Solution 2, a display layer (OLED) and a touch layer (TP) are added on the basis of Solution 1. To be specific, two ITO layers are added, and the two layers have an equal area. In Solution 3, an edge of the touch layer is inwardly retracted on the basis of Solution 2. A size of the display layer remains unchanged, and the edge of the touch layer is inwardly retracted by 0.5 mm relative to an edge of the display layer. In Solution 4, a part of a shielding structure on a bottom side of the display layer is added on the basis of Solution 3, a material of the shielding structure is a conductive material, and an area of the shielding structure on the bottom side of the display layer is greater than an area of the display layer. In Solution 5, a shielding structure on a side edge of the display structure is added on the basis of Solution 4. In Solution 5, the shielding structure includes a first part and a second part, the first part is located on a bottom side of the display layer, the second part surrounds a periphery of a side surface of the display structure, and a height by which the second part protrudes relative to the first part exceeds the touch layer, that is, a vertical distance between a top surface of the touch layer and the first part is less than a vertical distance between a top end of the second part and the first part.

In FIG. 23B, a curve labeled with the numeral 1 inside a triangle represents a total absorption loss generated in Solution 1, a curve labeled with the numeral 2 inside a triangle represents a total absorption loss generated in Solution 2, a curve labeled with the numeral 3 inside a triangle represents a total absorption loss generated in Solution 3, a curve labeled with the numeral 4 inside a triangle represents a total absorption loss generated in Solution 4, and a curve labeled with the numeral 5 inside a triangle represents a total absorption loss generated in Solution 5. Refer to FIG. 23B. Because there is no display structure in Solution 1, the absorption loss generated by Solution 1 is the lowest. In Solution 2, the display structure is added, both the display layer and the touch layer of the display structure can generate an absorption loss, and there is no shielding structure or a solution for reducing the absorption loss in Solution 2. Therefore, the absorption loss generated in Solution 2 is the largest. In Solution 3, a part of an absorption loss can be reduced by inwardly retracting the edge of the touch layer relative to the edge of the display layer, but there is no shielding structure in Solution 3. Therefore, the absorption loss generated in Solution 3 ranks second, and is less than the absorption loss generated in Solution 2, but is greater than an absorption loss generated in another solution. In Solution 4, the shielding structure is disposed on the bottom side of the display layer, but the area of the shielding structure is greater than the area of the display layer. With reference to an inwardly retracted edge of the touch layer, the absorption loss generated in Solution 4 is less than the absorption loss generated in Solution 3, and the absorption loss generated in Solution 4 ranks third. In Solution 5, the shielding structure on the periphery of the side surface of the display structure is added on the basis of Solution 4. The absorption loss generated in Solution 5 is less than the absorption loss generated in Solution 4, and the absorption loss generated in Solution 5 ranks fourth and is only greater than the absorption loss generated in Solution 1.

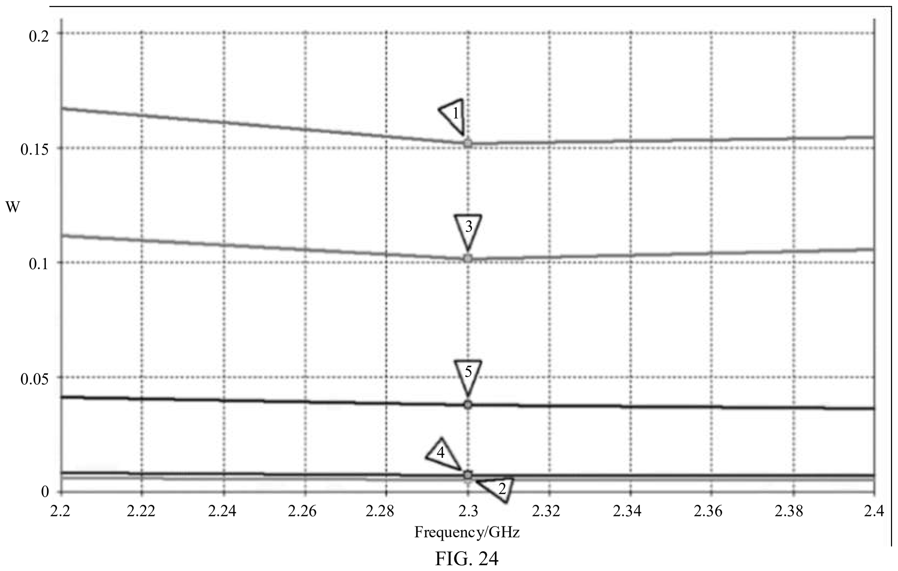

FIG. 24 is a curve comparison diagram of absorption losses generated by materials of different structures based on Solution 4 shown in FIG. 23A. In FIG. 24, a curve labeled with the numeral 1 inside a triangle represents a sum of absorption losses generated by all metal structures in Solution 4 shown in FIG. 23A, a curve labeled with the numeral 2 inside a triangle represents an absorption loss generated by the shielding structure (in a copper material) in Solution 4 shown in FIG. 23A, a curve labeled with the numeral 3 inside a triangle represents an absorption loss generated by the display structure (including the display layer and the touch layer, and a material of the display structure is ITO) in Solution 4 shown in FIG. 23A, a curve labeled with the numeral 4 inside a triangle represents an absorption loss generated by a metal structure on a circuit board in Solution 4 shown in FIG. 23A, and a curve labeled with the numeral 5 inside a triangle represents an absorption loss generated by a metal side frame (in a stainless steel material) in Solution 4 shown in FIG. 23A. It can be learned from FIG. 24 that, in all structures of the terminal device, the absorption loss generated by the display structure is the largest.

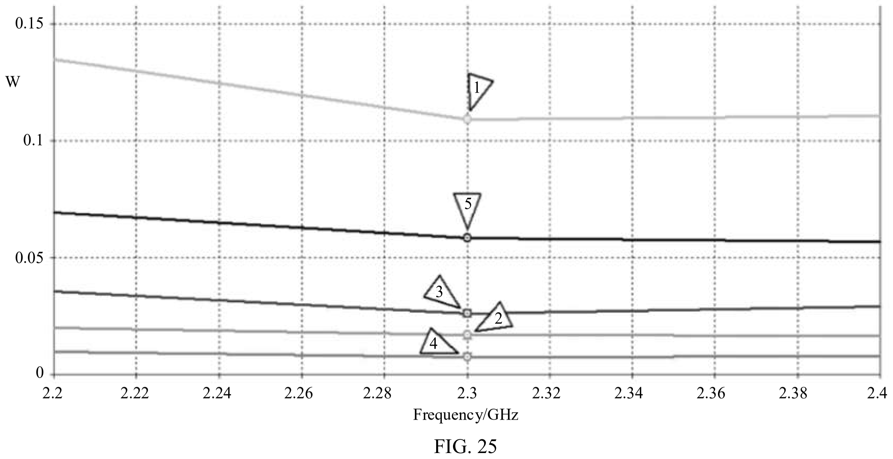

FIG. 25 is a curve comparison diagram of absorption losses generated by materials of different structures based on Solution 5 shown in FIG. 23A. In FIG. 25, a curve labeled with the numeral 1 inside a triangle represents a sum of absorption losses generated by all metal structures in Solution 5 shown in FIG. 23A, a curve labeled with the numeral 2 inside a triangle represents an absorption loss generated by the shielding structure (in a copper material) in Solution 5 shown in FIG. 23A, a curve labeled with the numeral 3 inside a triangle represents an absorption loss generated by the display structure (including the display layer and the touch layer, and a material of the display structure is ITO) in Solution 5 shown in FIG. 23A, a curve labeled with the numeral 4 inside a triangle represents an absorption loss generated by a metal structure on a circuit board in Solution 5 shown in FIG. 23A, and a curve labeled with the numeral 5 inside a triangle represents an absorption loss generated by a metal side frame (in a stainless steel material) in Solution 5 shown in FIG. 23A. It can be learned from FIG. 25 that, in all structures of the terminal device, the absorption loss generated by the metal side frame is the largest, and the absorption loss generated by the display structure ranks second.

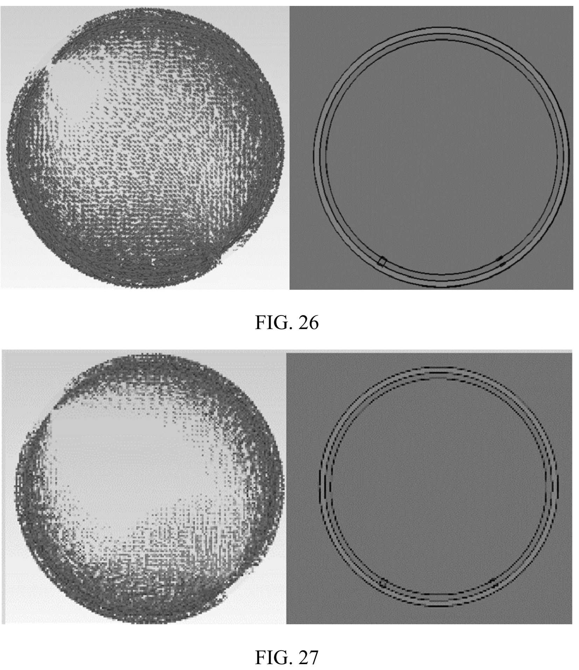

FIG. 26 is a diagram of an antenna current and electric field distribution in Solution 2 in FIG. 23A. FIG. 27 is a diagram of an antenna current and electric field distribution in Solution 5 in FIG. 23A. It can be learned, by comparing FIG. 26 and FIG. 27, that, in Solution 2, because the shielding structure and the inwardly retracted touch layer are not designed for the display structure, a current and an electric field are divergent, and there is much current distribution at an in-screen position of the display structure. It is proved that the display structure couples a current of the antenna, and causes an absorption loss to the antenna. However, in the current distribution diagram of Solution 5 shown in FIG. 27, it can be learned that because Solution 5 has the shielding structure and has a design of the inwardly retracted touch layer, a current and an electric field in Solution 5 are centralized, the current and the electric field are centrally distributed at a position of a side frame, and a small current is distributed in the screen of the display structure. Therefore, it can be proved that Solution 5 can reduce an absorption loss of the display structure.

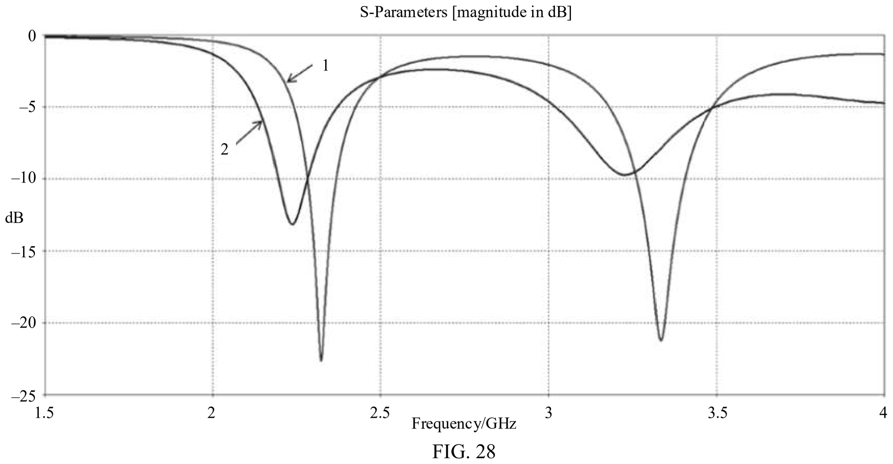

FIG. 28 shows a comparison between an S11 curve diagram of an antenna system in a solution with a shielding structure and an S11 curve diagram of an antenna system of a terminal device in which no shielding structure is disposed according to specific implementations of this application. In FIG. 28, a curve 1 represents a return loss of an antenna in an embodiment in which the shielding structure is disposed on a periphery of a display structure, and a curve 2 represents a return loss of an antenna in an embodiment in which no shielding structure is disposed on a periphery of a display structure. It can be learned that a technical means in which the shielding structure is disposed on the periphery of the display structure has little impact on the S11 curve of the antenna. The return loss of the antenna in the embodiment in which the shielding structure is disposed on the periphery of the display structure is lower. Therefore, in this application, disposing the shielding structure on the second surface and the side surface of the display structure can effectively resolve a problem of an absorption loss of the display structure on the antenna, and help improve performance of the antenna.

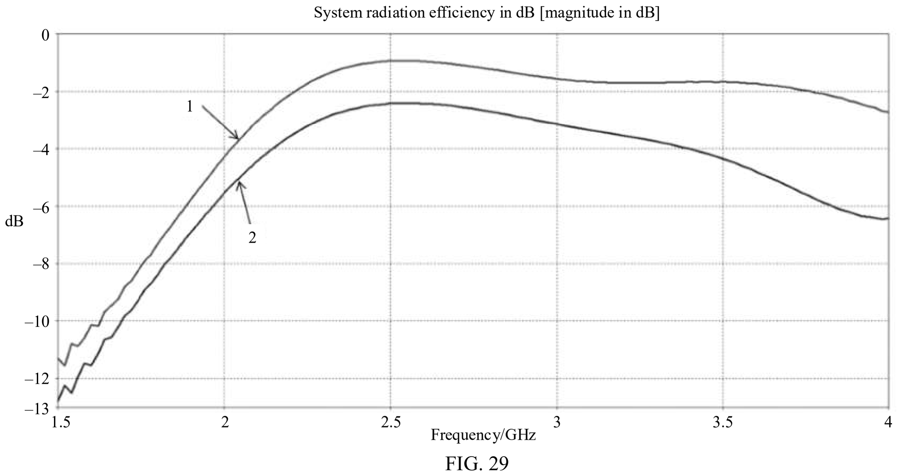

FIG. 29 shows a comparison between a curve diagram of radiation efficiency of an antenna system in a solution with a shielding structure and a curve diagram of radiation efficiency of an antenna system of a terminal device in which no shielding structure is disposed according to specific implementations of this application. In FIG. 29, a curve 1 represents radiation efficiency of an antenna in an embodiment in which the shielding structure is disposed on a periphery of a display structure, and a curve 2 represents radiation efficiency of an antenna in an embodiment in which no shielding structure is disposed on a periphery of a display structure. It can be learned that the antenna in the embodiment in which the shielding structure is disposed on the periphery of the display structure has better radiation efficiency, and radiation efficiency of the antenna is improved by 1.5 dB. Therefore, in this application, disposing the shielding structure on the second surface and the side surface of the display structure can effectively resolve a problem of an absorption loss of the display structure on the antenna, and help improve radiation efficiency of the antenna.

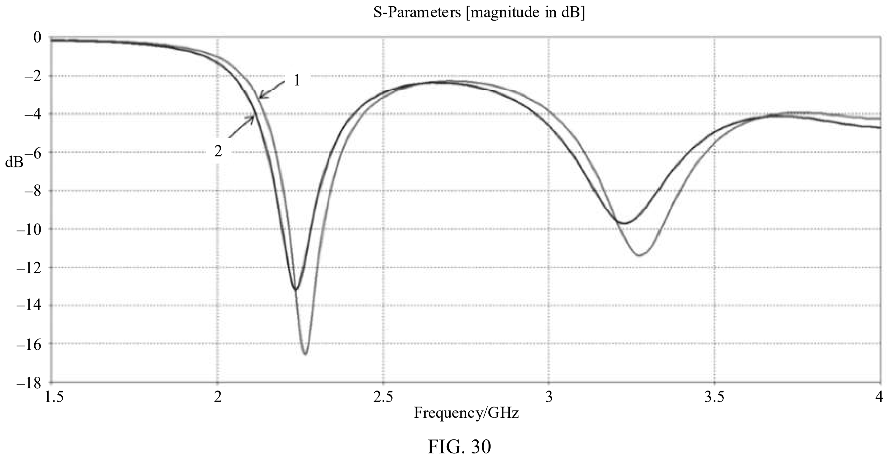

FIG. 30 shows a comparison between an S11 curve diagram of an antenna system in a solution in which an edge of a touch layer is inwardly retracted and an S11 curve diagram of an antenna system in a solution in which a touch layer is not designed to inwardly retract in a display structure according to specific implementations of this application. In FIG. 30, a curve 1 represents a return loss of the antenna system in the solution in which the edge of the touch layer is inwardly retracted in a display structure. Specifically, the edge of the touch layer is inwardly retracted by 0.5 mm. A curve 2 represents a return loss of an antenna in an embodiment in which the touch layer is not designed to inwardly retract in the display structure. It can be learned that a technical means in which the edge of the touch layer is inwardly retracted has small impact on the S11 curve of the antenna. The solution in which the edge of the touch layer is inwardly retracted in the display structure can obtain a lower return loss of the antenna. Therefore, in this application, the solution in which the edge of the touch layer is inwardly retracted can effectively resolve a problem of an absorption loss of the display structure on the antenna, and help improve performance of the antenna.

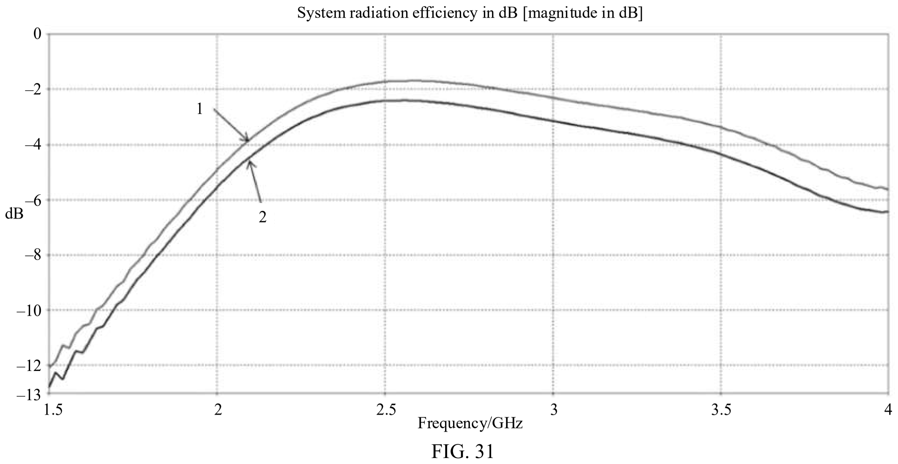

FIG. 31 shows a comparison between a curve diagram of radiation efficiency of an antenna system in a solution in which an edge of a touch layer is inwardly retracted and a curve diagram of radiation efficiency of an antenna system in a solution in which a touch layer is not designed to inwardly retract according to specific implementations of this application. In FIG. 31, a curve 1 represents radiation efficiency of an antenna in an embodiment in which the edge of the touch layer is inwardly retracted. Specifically, the edge of the touch layer is inwardly retracted by 0.5 mm, and radiation efficiency of the antenna is improved by 0.7 dB. A curve 2 represents radiation efficiency of an antenna in an embodiment of the solution in which the touch layer is not designed to inwardly retract. It can be learned that radiation efficiency of the antenna in the solution in which the edge of the touch layer is inwardly retracted in a display structure is better. Therefore, in this application, the edge of the touch layer is inwardly retracted, so that a problem of an absorption loss of the display structure on the antenna can be effectively resolved, thereby helping improve radiation efficiency of the antenna.

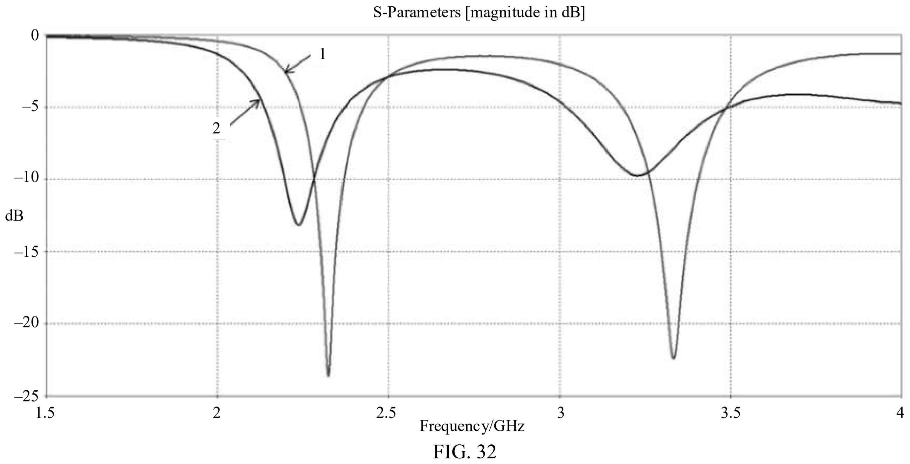

FIG. 32 shows a comparison between an S11 curve diagram of an antenna system in a solution in which a shielding structure is disposed and an edge of a touch layer is inwardly retracted and an S11 curve diagram of an antenna system in a solution in which no shielding structure is disposed and a touch layer is not designed to inwardly retract in a display structure according to specific implementations of this application. In FIG. 32, a curve 1 represents a return loss of the antenna system in the solution in which the shielding structure is disposed and the edge of the touch layer is inwardly retracted in the display structure. Specifically, the edge of the touch layer is inwardly retracted by 0.5 mm. A curve 2 represents a return loss of an antenna in an embodiment in which no shielding structure is disposed and the touch layer is not designed to inwardly retract in the display structure. It can be learned that the technical means in which the shielding structure is disposed and the edge of the touch layer is inwardly retracted has small impact on the S11 curve of the antenna. The solution in which the shielding structure is disposed and the edge of the touch layer is inwardly retracted in the display structure can obtain a lower return loss of the antenna. Therefore, in this application, the solution in which the shielding structure is disposed and the edge of the touch layer is designed to inwardly retract can effectively resolve a problem of an absorption loss of the display structure on the antenna, and help improve performance of the antenna.

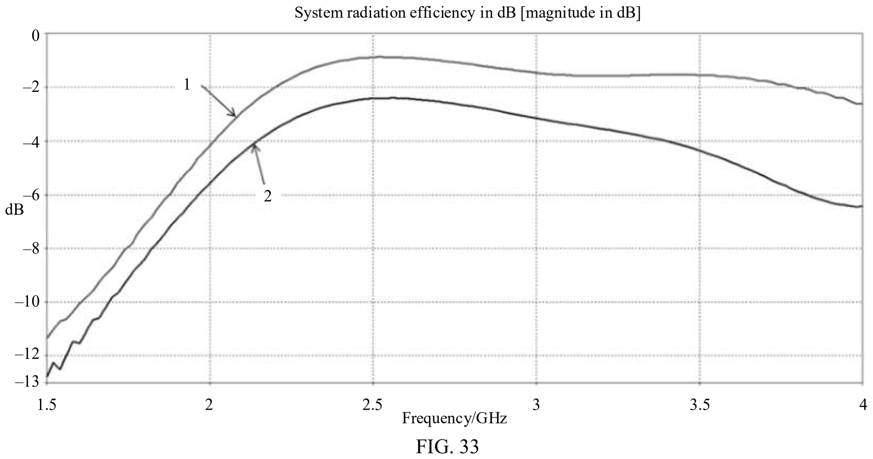

FIG. 33 shows a comparison between a curve diagram of radiation efficiency of an antenna system in a solution in which a shielding structure is disposed and an edge of a touch layer is inwardly retracted and a curve diagram of radiation efficiency of an antenna system in a solution in which no shielding structure is disposed and a touch layer is not designed to inwardly retract according to specific implementations of this application. In FIG. 33, a curve 1 represents radiation efficiency of an antenna in an embodiment of the solution in which the shielding structure is disposed on a periphery of a display structure and the edge of the touch layer is inwardly retracted. Specifically, the edge of the touch layer is inwardly retracted by 0.5 mm, and radiation efficiency of the antenna is improved by 1.6 dB. A curve 2 represents radiation efficiency of an antenna in an embodiment in which no shielding structure is disposed on a periphery of a display structure and the touch layer is not designed to inwardly retract. It can be learned that radiation efficiency of the antenna in the embodiment in which the shielding structure is disposed on the periphery of the display structure and the edge of the touch layer is inwardly retracted is better. Therefore, in this application, the shielding structure is disposed on the second surface and the side surface of the display structure, and the edge of the touch layer is inwardly retracted. This can effectively resolve a problem of an absorption loss of the display structure on the antenna, and help improve radiation efficiency of the antenna.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application. The foregoing descriptions are merely specific implementations of this application, but are not intended to limit the protection scope of this application. Any variation or replacement readily figured out by a person skilled in the art within the technical scope disclosed in this application shall fall within the protection scope of this application. When no conflict occurs, the implementations of this application and the features in the implementations may be mutually combined. Therefore, the protection scope of this application shall be subject to the protection scope of the claims.

## Claims

1. A terminal device, comprising:
a display structure, comprising a first surface, a second surface, and a side surface, wherein the first surface and the second surface are disposed opposite to each other, at least a part of the first surface forms a display surface of a screen of the terminal device, and an orientation of the side surface differs from that of the first surface;
a shielding structure, comprising a conductive material, wherein the shielding structure comprises a first part and a second part, the first part is located on a side that is of the second surface and that is away from the first surface, the first part covers at least a part of the second surface, and the second part is located on a periphery of the side surface and directly faces at least a part of the side surface; and
an antenna, comprising a radiator, wherein the radiator is located on the periphery of the side surface; and
the second part is located between the radiator and the side surface, to isolate at least a part of a signal between the radiator and the display structure, and in a direction perpendicular to the side surface, a distance between the radiator and the second part is greater than a distance between the second part and the side surface.

2. The terminal device according to claim 1, wherein the second part is interconnected with the first part, so that the shielding structure forms an integrated film structure or plate structure with a bent edge.

3. The terminal device according to claim 1 or 2, wherein the first part is attached to the second surface; and in a first direction, a vertical distance between the first surface and the second surface is a first size, a height by which a top of the second part protrudes relative to the first part is a second size, the first direction is a direction perpendicular to the second surface, the first size is less than or equal to the second size, and the top of the second part is an end that is of the second part and that is away from the first part.

4. The terminal device according to claim 3, wherein the terminal device comprises a cover and a side frame, the radiator is at least a part of the side frame, the cover is stacked outside the first surface of the display structure and is connected to the side frame, an ink layer is disposed on an inner surface of the cover, the ink layer is correspondingly disposed at an edge of the first surface and a periphery of the edge, and there is a gap between the top of the second part and the ink layer.

5. The terminal device according to any one of claims 1 to 4, wherein there is a gap between the second part and the side surface of the display structure, or the second part is attached to the side surface of the display structure.

6. The terminal device according to any one of claims 1 to 5, wherein the display structure comprises a display layer and a touch layer, the touch layer and the display layer are stacked, the display layer is located between the touch layer and the first part, a vertical distance between a surface that is of the touch layer and that is away from the display layer and the first part is less than or equal to the height by which the top of the second part protrudes relative to the first part, and the top of the second part is the end that is of the second part and that is away from the first part.

7. The terminal device according to claims 1 to 5, wherein the display structure comprises a display layer and a touch layer, the touch layer and the display layer are stacked, and the display layer is located between the touch layer and the first part; and in the direction perpendicular to the side surface, an edge of the touch layer is inwardly retracted relative to an edge of the display layer, and a distance between the edge of the touch layer and the second part is greater than a distance between the side surface and the second part.

8. The terminal device according to claim 6, wherein a size of the edge that is of the touch layer and that is inwardly retracted relative to the edge of the display layer ranges from 0.5 mm to 1 mm.

9. The terminal device according to claim 7 or 8, wherein the vertical distance between the surface that is of the touch layer and that is away from the display layer and the first part is less than or equal to the height by which the top of the second part protrudes relative to the first part, and the top of the second part is the end that is of the second part and that is away from the first part.

10. The terminal device according to any one of claims 1 to 9, wherein the conductive material of the shielding structure is at least one of stainless steel, silver paste, copper, or conductive fabric, or a combination of at least two thereof.

11. The terminal device according to any one of claims 2 to 10, wherein the second part is connected to an edge of the first part, the second part forms a surrounding structure with an opening, the surrounding structure surrounds the first part, and the opening is used to provide clearance for a component in the terminal device.

12. A terminal device, comprising:
a display structure, comprising a first surface and a second surface that are disposed opposite to each other, and a side surface connected between the first surface and the second surface, wherein at least a part of the first surface forms a display surface of a screen of the terminal device, the display structure comprises a display layer and a touch layer that are stacked, and an edge of the touch layer is inwardly retracted relative to an edge of the display layer; and
an antenna, comprising a radiator, wherein the radiator is located on a periphery of the side surface and is spaced from the display structure, and in a direction perpendicular to the side surface, a distance between the radiator and the edge of the touch layer is greater than a distance between the radiator and the edge of the display layer.

13. The terminal device according to claim 12, wherein a size of the edge that is of the touch layer and that is inwardly retracted relative to the edge of the display layer ranges from 0.5 mm to 1 mm.

14. The terminal device according to claim 12 or 13, wherein the terminal device further comprises a shielding structure, the shielding structure comprises a conductive material, and a part of the shielding structure is located between the side surface and the radiator, and is configured to isolate at least a part of a signal between the radiator and the display structure.

15. The terminal device according to claim 14, wherein the shielding structure comprises a first part and a second part, the first part is connected to the second surface and covers at least a part of the second surface, the second part is located on the periphery of the side surface, and there is a gap between the second part and the side surface of the display structure, or the second part is attached to the side surface of the display structure.

16. The terminal device according to claim 15, wherein a vertical distance between a surface that is of the touch layer and that is away from the display layer and the first part is less than a height by which a top of the second part protrudes relative to the first part, and the top of the second part is an end that is of the second part and that is away from the first part.

17. A terminal device, comprising:
a display structure, comprising a first surface and a second surface that are disposed opposite to each other, and a side surface connected between the first surface and the second surface, wherein at least a part of the first surface forms a display surface of a screen of the terminal device, the display structure comprises a substrate, a main structure, and an edge structure, the substrate comprises a top surface and a bottom surface that are disposed opposite to each other, the main structure and the edge structure are formed on the top surface of the substrate, the main structure comprises a display layer and a touch layer that are stacked in a direction perpendicular to the top surface, the edge structure is at least partially disposed around a periphery of the main structure, the edge structure comprises a shielding wall, and in a direction perpendicular to the side surface, the shielding wall covers at least a part of the main structure; and
an antenna, comprising a radiator, wherein the radiator is located on a periphery of the side surface and is spaced from the display structure; and
in the direction perpendicular to the side surface, the shielding wall is located between the radiator and the main structure, to isolate at least a part of a signal between the radiator and the main structure, and a distance between the radiator and the shielding wall is greater than a distance between the shielding wall and the main structure.

18. The terminal device according to claim 17, wherein the edge structure comprises an isolation part, the isolation part is located between the shielding wall and the main structure, the isolation part specifically has an accommodation space, and the accommodation space is configured to accommodate a conductive material that flows from the main structure to the isolation part in a process of manufacturing the main structure.

19. The terminal device according to claim 17 or 18, wherein the display structure further comprises a shielding layer, the shielding layer is located on a side of the bottom surface of the substrate, and the shielding layer covers at least a part of the main structure.

20. The terminal device according to claim 19, wherein the shielding layer is electrically connected to the shielding wall through a via hole on the substrate.

21. The terminal device according to any one of claims 17 to 20, wherein the shielding wall forms a surrounding structure with an opening, the display structure comprises an edge cable, the edge cable is stacked on a side that is of the edge structure and that is away from the substrate, the edge cable is electrically connected to the main structure, and the edge cable passes through the opening and extends to a periphery of the edge structure.
